# EUROPEAN PATENT SPECIFICATION

(11) **EP 4 529 144 B1**
(45) Date of publication and mention of the grant of the patent: **04.11.2026**
(21) Application number: 23905287.1
(22) Date of filing: 22.08.2023
(51) Int. Cl.: H04M 1/02, H04M 1/18

(54) **SCREEN DECORATING MEMBER AND ELECTRONIC DEVICE**
BILDSCHIRMDEKORATIONSELEMENT UND ELEKTRONISCHE VORRICHTUNG
ÉLÉMENT DE DÉCORATION D'ÉCRAN ET DISPOSITIF ÉLECTRONIQUE

(30) Priority: 19.12.2022 CN 202211633795
(43) Date of publication of application: 26.03.2025
(73) Proprietor: Honor Device Co., Ltd., Shenzhen, Guangdong 518040 (CN)
(72) Inventor: WEI, Yameng, Shenzhen, Guangdong 518040 (CN); YUAN, Leibo, Shenzhen, Guangdong 518040 (CN); FENG, Lei, Shenzhen, Guangdong 518040 (CN)
(74) Representative: MERH-IP Matias Erny Reichl Hoffmann Patentanwälte PartG mbB
(86) International application number: PCT/CN2023/114240
(87) International publication number: WO 2024/131108

(56) References cited:
- CN-A- 110 086 897
- CN-A- 111 503 453
- CN-A- 114 863 808
- CN-A- 115 376 413
- CN-U- 209 914 239
- CN-U- 213 846 735
- CN-U- 216 795 041
- KR-A- 20220 079 396
- US-A1- 2013 331 155
- US-A1- 2016 119 014

## Description

### TECHNICAL FIELD

This application relates to the technical field of electronic devices, and in particular, to a screen decorating member and an electronic device.

### BACKGROUND

With continuous development of display technologies, foldable terminals (for example, foldable mobile phones) gradually become a development trend of future mobile electronic products. A foldable terminal can obtain a large display area in an unfolded state to improve a visual effect, can obtain a small volume in a folded state to facilitate carrying by a user, and therefore becomes popular among an increasing number of users.

A structure for implementing display of a foldable terminal is a flexible display. However, during falling of the foldable terminal, the flexible display has a problem of being vulnerable to damage due to impact from other structures of the foldable terminal.

CN110086897A discloses a housing of an electronic main body unit comprising a mid-frame that includes a non-glass subframe positioned around the periphery of a glass main frame to serve a decorative purpose and to enhance the structural integrity and impact resistance of the mid-frame.
US2016/119014A1 discloses a metallic protective case including a first metallic case portion adapted to fit over a front portion of electronic device and a second metallic case portion adapted to fit over a rear portion of electronic device.
US2013/331155A1 discloses a housing, which is comprised in a mobile device case, including one or more corners, each of which defines an inner surface and outer surface, as well as defines an aperture, and one or more corner elements, which are sized to be removably inserted and securable within the aperture.
CN115376413A discloses a decorative element of an electronic device comprises a support section configured to support the non-folding region of flexible display and a decorative section, which encircles the periphery of flexible display's edge extending from the edge of support section.

### SUMMARY

To resolve the foregoing technical problem, this application provides a screen decorating member and an electronic device, to avoid a problem of the flexible display being vulnerable to damage due to impact from other structures of the foldable terminal.

The present invention is defined by the appended independent claims. Preferred embodiments are set forth in the dependent claims. According to a first aspect, embodiments of this application provide a screen decorating member in an electronic device. The electronic device includes a screen body. The screen decorating member includes a first decorating section, a second decorating section, and a bent section, and the second decorating section includes a first end portion and a second end portion. The first decorating section is connected to the first end portion of the second decorating section by the bent section, the second end portion is located on a side of the first end portion away from the bent section, and the first decorating section, the second decorating section, and the bent section are configured for being disposed around at least part of a circumference of the screen body. The second end portion, optionally also the bent section,are provided with a stress buffer structure.

The stress buffer structure is disposed at the bent section and/or the second end portion to implement the protection of the screen body, to avoid a case that when the electronic device falls, the screen body and/or the screen decoration vibrates or displaces under the action of impact and the bent section and/or the second end portion of the screen decorating member cause/causes damage to the screen body.

For example, when the electronic device is a foldable terminal, the screen body is a flexible display. The stress buffer structure is disposed at the second end portion to implement the protection of a bent display section of the flexible display, to avoid a case that when the foldable terminal falls in a folded state, the second end portion of the second decorating section of the screen decorating member punctures the bent display section of the flexible display under the action of impact to cause damage to the flexible display, and avoid a case that when the foldable mobile phone falls in an unfolded state, the bent section collides with an edge of the flexible display to cause damage to the flexible display. In addition, with the arrangement of the stress buffer structure, the frequency of an impact sound of a middle frame when the foldable terminal is closed is reduced, and the timbre is deeper and steadier.

For example, when the electronic device is a foldable terminal, the screen body is a flexible display. When the electronic device is a bar-type terminal, the screen body is a display.

For example, two second decorating sections are provided, two bent sections are provided, the first decorating section is located between the two second decorating sections, one bent section is connected to the first decorating section and one of the second decorating sections, the other bent section is connected to the first decorating section and the other second decorating section, the two second decorating sections extend in a same direction, and an extension direction of the first decorating section is different from an extension direction of the second decorating section, for example, the extension direction of the first decorating section is perpendicular to the extension direction of the second decorating section.

It should be noted that a position provided with the stress buffer structure is, but not limited to, the bent section and/or the second end portion, and any screen decorating member provided with a stress buffer structure in a region that may cause damage to the screen body falls within the scope of protection of this application.

The electronic device further includes a housing, the screen body is disposed on a side of the housing, and the screen decorating member includes a first decorating surface and a second decorating surface that are opposite to each other in a first direction, where the first direction is a thickness direction of the screen decorating member; the second decorating surface is locally recessed in the first direction toward an edge of the screen body to form a notch; a part corresponding to the notch in the screen decorating member in the first direction is a blocking portion, and the blocking portion is configured for blocking the edge of the screen body; and another part other than the blocking portion in the screen decorating member is a fixing portion, and the fixing portion is configured for being fixed at a circumference of the housing. The structure of the screen decorating member is simple.

For example, the housing is a body in the embodiments, is specifically a middle frame, and is more specifically an exterior member of the middle frame.

In some possible implementations, based on that the screen decorating member includes the fixing portion and the blocking portion, the second decorating section further includes a main body portion located between the first end portion and the second end portion; the second end portion includes a first notch, and the main body portion includes a second notch; a width of the first notch is greater than a width of the second notch, the width of the notch is a size of the notch in a second direction, and the second direction is a direction of the blocking portion pointing to the fixing portion; and the first notch includes a first part and a second part that are adjacent in the second direction, the first part is a part that is in the first notch and that has a same width as the second notch, and the stress buffer structure includes the second part. To be specific, the size of the notch of the second end portion is increased, and a width of the fixing portion of the second end portion is reduced, to reduce the strength of the second end portion. The second end portion with reduced strength releases partial stress after impacting the bent display section of the flexible display, thereby achieving the objective of protecting the flexible display. In addition, because only the size of the notch is increased, the appearance effect of the second end portion is not affected, the structure is simple, the process steps are simple, and the costs are low.

In some possible implementations, a width of the second part gradually decreases in a third direction, and the width of the fixing portion of the second end portion gradually increases, where the third direction is a direction of the second end portion pointing to the main body portion. With such an arrangement, while the overall strength of the screen decorating member is ensured, the second end portion can further release partial stress after impacting the bent display section of the flexible display, thereby protecting the flexible display.

In some possible implementations, based on that the stress buffer structure includes the second part, a soft structure is disposed at the second part, and the stress buffer structure further includes the soft structure. The soft structure is disposed at the second part of the second end portion, i.e., the width of the fixing portion is still an equal-width design (only a material in a partial region at the second end portion is different). With such an arrangement, a common material is still kept at the appearance of the screen decorating member to keep the appearance effect and the overall strength of the screen decorating member. In addition, when the foldable terminal falls in a folded state, the soft structure has an instantaneous deformation to release stress, thereby achieving the objective of protecting the flexible display.

In some possible implementations, based on that the stress buffer structure further includes the soft structure, when the width of the second part gradually decreases in the third direction, a width of the soft structure gradually increments on a gradient in the third direction, where the width of the soft structure is a size of the soft structure in the second direction. With such an arrangement, while the overall strength of the screen decorating member is ensured, the second end portion can further release partial stress through the soft structure after impacting the bent display section of the flexible display, thereby protecting the flexible display.

Based on that the screen decorating member includes the fixing portion and the blocking portion, the blocking portion includes a blocking surface facing the screen body; the blocking surface and a side wall of the fixing portion define the notch, and at least one groove is opened in the blocking surface at the second end portion; and the stress buffer structure includes the groove. With such an arrangement, the strength of the second end portion can be reduced. The second end portion with reduced strength releases partial stress through the groove after impacting the bent display section of the flexible display, thereby achieving the objective of protecting the flexible display. In addition, an opening of the groove is located at the second decorating surface instead of being located at the first decorating surface. Therefore, the appearance effect of the second end portion is not affected, the structure is simple, the process steps are simple, and the costs are low.

In some possible implementations, based on that the stress buffer structure includes the groove, a volume of the groove gradually decreases in a unit area of the blocking surface in a third direction, and the third direction is a direction of the second end portion pointing to the first end portion. With such an arrangement, while the overall strength of the screen decorating member is ensured, the second end portion can further release partial stress through the soft structure after impacting the bent display section of the flexible display, thereby protecting the flexible display.

In some possible implementations, based on that the volume of the groove gradually decreases, a plurality of grooves are provided, and a distance between two adjacent grooves gradually increases in the third direction. To be specific, the density of the grooves is reduced, so that while the overall strength of the screen decorating member is ensured, the second end portion can further release partial stress through the soft structure after impacting the bent display section of the flexible display, thereby protecting the flexible display.

In some possible implementations, based on that the volume of the groove gradually decreases, a plurality of grooves are provided, and volumes of the plurality of grooves gradually decrease in the third direction. To be specific, the size of the groove is reduced, so that while the overall strength of the screen decorating member is ensured, the second end portion can further release partial stress through the soft structure after impacting the bent display section of the flexible display, thereby protecting the flexible display.

In some possible implementations, based on that the volume of the groove gradually decreases, lengths, widths, and/or depths of the plurality of grooves gradually decrease in the third direction; the width of the groove is a size of the groove in the third direction, and the third direction is a direction of the second end portion pointing to a main body portion; the width of the groove is a size of the groove in a second direction, and the second direction is a direction of the blocking portion pointing to the fixing portion; and the depth of the groove is a size of the groove in the first direction.

In some possible implementations, based on that the screen decorating member includes the fixing portion and the blocking portion, the second decorating section further includes a main body portion located between the first end portion and the second end portion; and a hardness of the blocking portion at the second end portion is less than a hardness of the blocking portion at the main body portion; and the stress buffer structure includes the blocking portion at the second end portion. Because the blocking portion at the second end portion is soft, when the foldable terminal falls in a folded state, the soft blocking portion has an instantaneous deformation under the action of impact to release stress, thereby achieving the objective of protecting the flexible display.

For example, a material of the blocking portion at the second end portion is different from a material of the blocking portion at the main body portion, making the hardness of the blocking portion at the second end portion less than the hardness of the blocking portion at the main body portion.

In some possible implementations, based on that the stress buffer structure includes the blocking portion at the second end portion, the first decorating surface is exposed from an outer side, and a protective layer is disposed on the first decorating surface and is configured for blocking the first decorating surface, to avoid poor appearance of the screen decorating member when the material of the blocking portion at the second end portion is different from the material of the blocking portion at the main body portion.

In some possible implementations, a length of the second end portion is greater than or equal to 0.5 mm and is less than or equal to 10 mm; and the length of the second end portion is a size of the second end portion in a third direction, and the third direction is a direction of the second end portion pointing to the first end portion. In this way, the overall strength of the screen decorating member is not affected due to an excessively large length of the second end portion, and the effect of stress release is kept from failing due to an excessively small length of the second end portion. Therefore, in the embodiments of this application, the length of the second end portion is set between 0.5 mm and 10 mm, so that while good strength is ensured, stress can be released, to avoid a case that when the foldable terminal falls in a folded state, the second end portion of the second decorating section of the screen decorating member punctures the bent display section of the flexible display under the action of impact to cause damage to the flexible display.

For example, the length of the second end portion includes 0.5 mm, 1 mm, 1.5 mm, 2 mm, 2.5 mm, 3 mm, 3.5 mm, 4 mm, 4.5 mm, 5 mm, 5.5 mm, 6 mm, 6.5 mm, 7 mm, 7.5 mm, 8 mm, 8.5 mm, 9 mm, 9.5 mm, 10 mm, or the like.

In some possible implementations, based on that the screen decorating member includes the fixing portion and the blocking portion, the bent section includes a third notch, the first end portion includes a fourth notch, and the first decorating section includes a fifth notch; a width of the third notch is greater than widths/a width of the fourth notch and/or the fifth notch, the width of the notch is a size of the notch in a second direction, and the second direction is a direction of the blocking portion pointing to the fixing portion; and the third notch includes a third part and a fourth part that are adjacent in the second direction, the third part is a part that is in the third notch and that has a same width as the fourth notch and/or the fifth notch, and the stress buffer structure includes the fourth part. To be specific, the size of the notch at the bent section is increased, and the width of the fixing portion at the bent section is reduced, to avoid a case that when the electronic device falls (for example, the foldable terminal falls in an unfolded state), a corner position of the screen body collides with the fixing portion located at the bent section under the action of impact to cause damage to the screen body. In addition, because the size of the notch is increased, the structure is simple, the process steps are simple, and the costs are low.

In some possible implementations, based on that the stress buffer structure includes the fourth part, the bent section includes a first edge and a second edge, the first edge is in contact with the first end portion, and the second edge is in contact with the first decorating section; and a width of the fourth part gradually decreases from a preset position of the bent section to the first edge and/or the second edge, and a width of the fixing portion gradually increases. With such an arrangement, while the overall strength of the screen decorating member is ensured, the corner position of the screen body can be further kept from colliding with the fixing portion located at the bent section to avoid causing damage to the screen body, thereby protecting the screen body.

In some possible implementations, based on that the stress buffer structure includes the fourth part, a soft structure is disposed at the fourth part; and the stress buffer structure further includes the soft structure. The soft structure is disposed at the fourth part of the bent section, i.e., the width of the fixing portion is still an equal-width design (only a material in a partial region at the bent section is different). With such an arrangement, a common material is still kept at the appearance of the screen decorating member to keep the appearance effect and the overall strength of the screen decorating member and avoid a case that when the electronic device falls (for example, the foldable terminal falls in an unfolded state), the corner position of the screen body collides with the fixing portion located at the bent section to cause damage to the screen body.

In some possible implementations, based on that the stress buffer structure further includes the soft structure, when the width of the notch gradually decreases from the preset position of the bent section to the first edge and/or the second edge, a width of the soft structure gradually increases from the preset position of the bent section to the first edge and/or the second edge, and the width of the soft structure is a size of the soft structure in the second direction. With such an arrangement, while the overall strength of the screen decorating member is ensured, when the electronic device falls (for example, the foldable terminal falls in an unfolded state), the corner position of the screen body can be further kept from colliding with the fixing portion located at the bent section under the action of impact to avoid causing damage to the screen body.

In some possible implementations, based on that the screen decorating member includes the fixing portion and the blocking portion, at least one groove is opened in a side wall on a side of the fixing portion facing the notch; and the stress buffer structure includes the groove. With such an arrangement, the strength of the fixing portion can be reduced. The fixing portion with reduced strength releases partial stress through the groove after impacting the flexible screen body, thereby achieving the objective of protecting the screen body. In addition, an opening of the groove is located at the side wall of the fixing portion instead of being located on the surface exposed from the outer side. Therefore, the appearance effect of the bent section is not affected, the structure is simple, the process steps are simple, and the costs are low.

In some possible implementations, based on that the stress buffer structure includes the groove, the bent section includes a first edge and a second edge, the first edge is in contact with the first end portion, and the second edge is in contact with the first decorating member; and a volume of the groove gradually decreases in a unit area of the side wall from a preset position of the bent section to the first edge and/or the second edge. With such an arrangement, while the overall strength of the screen decorating member is ensured, when the electronic device falls (for example, the foldable terminal falls in an unfolded state), the corner position of the screen body can be further kept from colliding with the fixing portion located at the bent section under the action of impact to avoid causing damage to the screen body.

In some possible implementations, based on that the volume of the groove gradually decreases in the unit area of the blocking surface, a plurality of grooves are provided, and a distance between two adjacent grooves gradually increases from the preset position of the bent section to the first edge and/or the second edge. To be specific, the density of the grooves is reduced, so that while the overall strength of the screen decorating member is ensured, when the electronic device falls (for example, the foldable terminal falls in an unfolded state), the corner position of the screen body can be further kept from colliding with the fixing portion located at the bent section under the action of impact to avoid causing damage to the screen body.

Based on that the volume of the groove gradually decreases in the unit area of the blocking surface, a plurality of grooves are provided, and volumes of the plurality of grooves gradually decrease from the preset position of the bent section to the first edge and/or the second edge. To be specific, the size of the groove is reduced, so that while the overall strength of the screen decorating member is ensured, when the electronic device falls (for example, the foldable terminal falls in an unfolded state), the corner position of the screen body can be further kept from colliding with the fixing portion located at the bent section under the action of impact to avoid causing damage to the screen body.

Based on that a volume of the groove gradually decreases in a unit area of the blocking surface, lengths, widths, and/or depths of the plurality of grooves gradually decrease from the preset position of the bent section to the first edge and/or the second edge; the width of the groove is a size of the groove from the preset position of the bent section to the first edge and/or the second edge; the depth of the groove is a size of the groove in a second direction, and the second direction is a direction of the blocking portion pointing to the fixing portion; and the length of the groove is a size of the groove in the first direction.

In some possible implementations, based on that the screen decorating member includes the fixing portion and the blocking portion, a hardness of the fixing portion at the bent section is less than a hardness of the fixing portion at the first decorating section and a hardness of the fixing portion at the second decorating section; and the stress buffer structure includes the fixing portion of the bent section.

According to a second aspect, embodiments of this application provide an electronic device, including the screen decorating member according to the first aspect and a screen body, and having the same beneficial effects as the first aspect.

In some possible implementations, the electronic device includes a foldable terminal, and the foldable terminal further includes a rotating shaft structure and two bodies; the screen body includes a flexible display, and two screen decorating members are provided; the two bodies include a first body and a second body, and the two screen decorating members include a first screen decorating member and a second screen decorating member; one end of the rotating shaft structure is connected to the first body, and the other end is connected to the second body; the flexible display is located on a side of the rotating shaft structure, the first body, and the second body; the flexible display includes a bent display section and a first flat display section and a second flat display section that are located on two sides of the bent display section; the screen decorating members are located on a side of the flexible display away from the first body and the second body; and the first screen decorating member is configured for blocking a gap between an edge of the first flat display section and the first body, and the second screen decorating member is configured for blocking a gap between an edge of the second flat display section and the second body.

In some possible implementations, based on that the electronic device includes a foldable terminal, the foldable terminal further includes at least two attraction structures, the at least two attraction structures include a first attraction structure located in the first body and a second attraction structure located in the second body; when the foldable terminal is changed from an unfolded state to a folded state, an attractive force between the first attraction structure and the second attraction structure keeps the foldable terminal in a folded state; the attraction structures are disposed at a first end portion of a second decorating member or at a first decorating section; and the first end portion of the second decorating member or the first decorating section at which the attraction structures are disposed is provided with a stress buffer structure. The benefits that the frequency of an impact sound of a middle frame when the foldable terminal is closed is reduced and the timbre is deeper and steadier are clearer.

### BRIEF DESCRIPTION OF DRAWINGS

FIG. 1 is a schematic diagram of a structure of a foldable terminal according to an embodiment of this application;
FIG. 2 is an exploded view of the foldable terminal in FIG. 1;
FIG. 3 is a cross-sectional view of the foldable terminal in FIG. 1 in an AA' direction;
FIG. 4 is a schematic diagram of a front structure of a screen decorating member according to an embodiment of this application;
FIG. 5 is a schematic diagram of a rear structure of a screen decorating member according to an embodiment of this application;
FIG. 6 is a schematic diagram of a structure of a foldable terminal in a folded state according to an embodiment of this application;
FIG. 7 is a partial enlarged view of a BB region in the screen decorating member in FIG. 5;
FIG. 8 is a schematic diagram of a partial structure of a screen decorating member according to an embodiment of this application;
FIG. 9 is a schematic diagram of a partial structure of another screen decorating member according to an embodiment of this application;
FIG. 10 is a schematic diagram of a partial structure of another screen decorating member according to an embodiment of this application;
FIG. 11 is a schematic diagram of a partial structure of another screen decorating member according to an embodiment of this application;
FIG. 12 is a schematic diagram of a partial structure of another screen decorating member according to an embodiment of this application;
FIG. 13 is a schematic diagram of a partial structure of another screen decorating member according to an embodiment of this application;
FIG. 14 is a schematic diagram of a partial structure of another screen decorating member according to an embodiment of this application;
FIG. 15 is a schematic diagram of a partial structure of another screen decorating member according to an embodiment of this application;
FIG. 16 is a schematic diagram of a partial structure of another screen decorating member according to an embodiment of this application;
FIG. 17 is a schematic diagram of a partial structure of another screen decorating member according to an embodiment of this application;
FIG. 18 is a cross-sectional view of the screen decorating member in FIG. 12 in an FF' direction;
FIG. 19 is a schematic diagram of a partial structure of another screen decorating member according to an embodiment of this application;
FIG. 20 is a cross-sectional view of the screen decorating member in FIG. 19 in an II' direction;
FIG. 21 is a schematic diagram of a partial structure of another screen decorating member according to an embodiment of this application;
FIG. 22 is a cross-sectional view of the screen decorating member in FIG. 21 in a JJ' direction;
FIG. 23 is another cross-sectional view of the screen decorating member in FIG. 21 in a JJ' direction;
FIG. 24 is a schematic diagram of a partial structure of another screen decorating member according to an embodiment of this application;
FIG. 25 is a schematic diagram of a partial structure of another screen decorating member according to an embodiment of this application;
FIG. 26 is a diagram of a position relationship among a first screen decorating member, a second screen decorating member, and a blocking member according to an embodiment of this application;
FIG. 27 is a cross-sectional view of the first screen decorating member, the second screen decorating member, and the blocking member in FIG. 26 in an LL' direction;
FIG. 28 is a schematic diagram of a partial structure of a screen decorating member and a blocking member according to an embodiment of this application;
FIG. 29 is a schematic diagram of another partial structure of a screen decorating member and a blocking member according to an embodiment of this application;
FIG. 30 is a partial enlarged view of a CC region in the screen decorating member in FIG. 5;
FIG. 31 is a schematic top view of a structure of a bent section according to an embodiment of this application;
FIG. 32 is a schematic diagram of a structure of a fixing portion at a bent section according to an embodiment of this application;
FIG. 33 is a schematic diagram of a structure of another fixing portion at a bent section according to an embodiment of this application;
FIG. 34 is a schematic diagram of a structure of another fixing portion at a bent section according to an embodiment of this application;
FIG. 35 is a schematic diagram of a structure of another fixing portion at a bent section according to an embodiment of this application;
FIG. 36 is a schematic diagram of a structure of another fixing portion at a bent section according to an embodiment of this application; and
FIG. 37 is a cross-sectional view of the screen decorating member in FIG. 32 in a KK' direction.

### DESCRIPTION OF EMBODIMENTS

Technical solutions in embodiments of this application are described clearly and completely below with reference to the accompanying drawings in the embodiments of this application. Apparently, the described embodiments are a part rather than all of the embodiments of this application.

The term "and/or" used in this specification describes only an association relationship for describing associated objects and represents that three relationships may exist. For example, A and/or B may represent the following three cases: Only A exists, both A and B exist, and only B exists.

In the specification and claims of the embodiments of this application, the terms "first", "second", and the like are intended to distinguish between different objects but do not indicate a specific order of the objects. For example, a first target object, a second target object, and the like are intended to distinguish between different target objects, but are not intended to describe a specific order of the target objects.

In embodiments of this application, terms such as "illustrative" and "for example" are used for presenting an example, an instance, or an illustration. Any embodiment or design scheme described as an "exemplary" or "for example" in the embodiments of this application should not be explained as being more preferred or having more advantages than another embodiment or design scheme. In particular, the terms such as "exemplary" and "example" as used herein are intended to present the related concepts in a specific manner.

In the description of the embodiments of this application, "plurality" means two or more unless otherwise described. For example, a plurality of processing units are two or more processing units. A plurality of systems are two or more systems.

With rapid development of foldable terminals, an increasing number of foldable terminals are provided with flexible displays. In addition to a flexible display, a foldable terminal further includes a body supporting the flexible display. To keep a gap between the flexible display and the body from affecting the aesthetics of the foldable terminal, a screen decorating member is generally disposed at a position of the gap between the flexible display and the body, so that the gap formed between the flexible display and the body is blocked by the screen decorating member, an edge of the flexible display is protected, and the like. However, because the screen decorating member is exposed from an outer side of the foldable terminal, a hardness of the screen decorating member is high. It is found through research that when the foldable terminal falls, the hard screen decorating member impacts the flexible display under the action of impact, causing damage to the flexible display.

Based on this, embodiments of this application provide an electronic device. The electronic device may be a foldable terminal or may be a bar-type terminal. The electronic device provided in the embodiments of this application may be a mobile phone, a tablet computer, a personal digital assistant (personal digital assistant, PDA for short), an in-vehicle computer, a television, a smart wearable device, a smart home device, or the like. A specific form of the electronic device is not specially limited in the embodiments of this application. For ease of description, the following uses an example in which the electronic device is a mobile phone and the mobile phone is a foldable mobile phone for description.

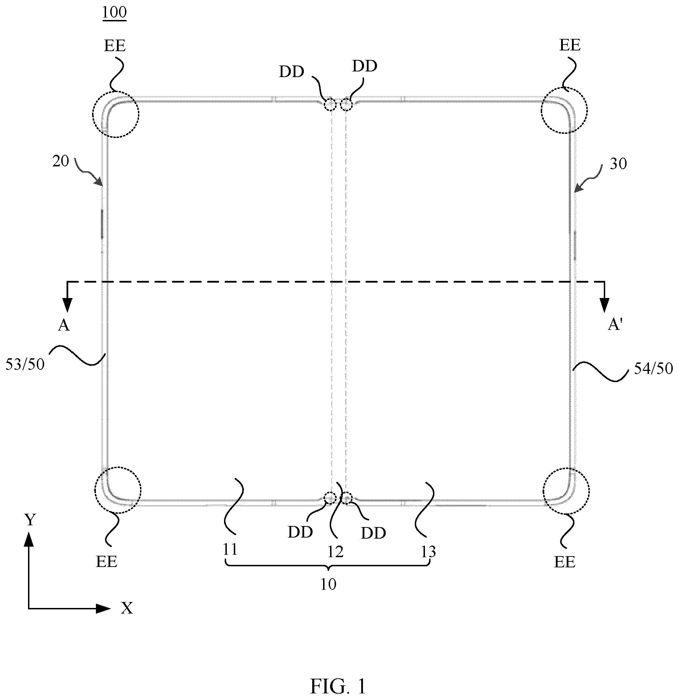

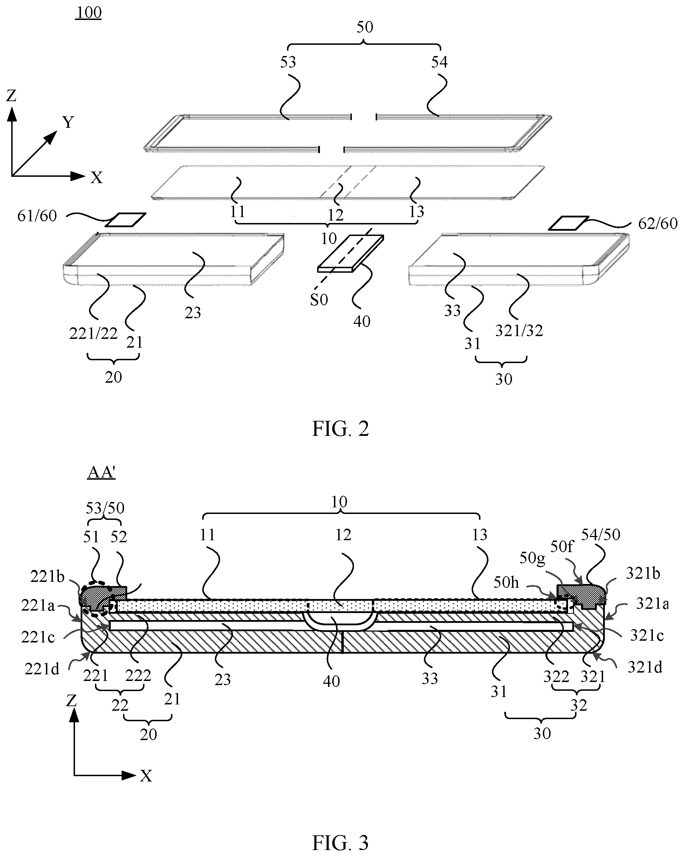

FIG. 1 is a schematic diagram of a structure of a foldable terminal according to an embodiment of this application. FIG. 2 is an exploded view of the foldable terminal in FIG. 1. As shown in FIG. 1 and FIG. 2, a foldable mobile phone 100 includes a flexible display (also referred to as a foldable screen or a flexible screen) 10.

The flexible display 10 includes, for example, an organic light-emitting diode (Organic Light Emitting Diode, OLED) display. A backlight module is not required in the OLED display, and a base substrate in the OLED display may be, for example, a flexible resin material, for example, polyethylene terephthalate (Polyethylene terephthalate, PET), so that the OLED display has a bendable characteristic. Certainly, a type of the flexible display 10 includes, but is not limited to, an OLED display. Any display that can be bent falls within the scope of protection of this application, for example, may be a liquid crystal display (Liquid Crystal Display, LCD), an LED display (including, for example, a Micro-LED display and a Mini-LED display), or the like.

It should be noted that, for ease of clearly describing subsequent structural features and positional relationships of the structural features, a positional relationship of the structures in the foldable mobile phone 100 is specified by using an X-axis direction, a Y-axis direction, and a Z-axis direction. The X-axis direction is a width direction of the foldable mobile phone 100 after being unfolded, the Y-axis direction is a length direction of the foldable mobile phone 100 after being unfolded, and the Z-axis direction (also referred to as a first direction) is a thickness direction of the foldable mobile phone 100 after being unfolded.

Still referring to FIG. 1 and FIG. 2, the foldable mobile phone 100 further includes structural components. The structural components include a first body 20, a second body 30, and a rotating shaft structure 40. In the X-axis direction, the first body 20 and the second body 30 are located on two sides of the rotating shaft structure 40, and the rotating shaft structure 40 is connected to the first body 20 and the second body 30. The first body 20, the rotating shaft structure 40, and the second body 30 may be configured for carrying the flexible display 10. The first body 20 and the second body 30 may respectively rotate around an axis SO of the rotating shaft structure 40, to implement a folded state, an unfolded state, or the like of the flexible display 10, i.e., to implement a folded state, an unfolded state, or the like of the foldable mobile phone 100. In some embodiments, the first body 20 and the second body 30 are symmetrically distributed about the axis SO.

During folding, a part of the flexible display 10 that is bent is a bent display section 12. In the X-axis direction, parts of the flexible display 10 located on two sides of the bent display section 12 are respectively a first flat display section 11 and a second flat display section 13. During the folding of the foldable mobile phone 100 from an unfolded state to a folded state, an angle between a plane in which the first flat display section 11 is located and a plane in which the second flat display section 13 is located changes with the bending of the bent display section 12, for example, changes from 180° to 0°.

It should be noted that, the first body 20 and the second body 30 may be folded in a light-emitting direction of the flexible display 10, or may be folded in a direction opposite to the light-emitting direction of the flexible display 10. This is not limited in the embodiments of this application.

It should be noted that the foldable mobile phone 100 can be folded at a plurality of positions. Correspondingly, the structural components may include a plurality of rotating shaft structures 40 and a plurality of bodies. For example, two rotating shaft structures 40 and three bodies may be included, and two adjacent bodies are connected by one rotating shaft structure 40. In this way, the foldable mobile phone 100 has two folding positions. It can be seen that the structural components include at least one rotating shaft structure 40 and at least two bodies, and two adjacent bodies are connected by one rotating shaft structure 40. For ease of description, the embodiments of this application are all described by using an example in which the structural components include one rotating shaft structure 40 and two bodies (i.e., the first body 20 and the second body 30).

It should be further noted that, in FIG. 1 and FIG. 2, an example in which the foldable mobile phone 100 is folded in a longitudinal direction (i.e., the Y-axis direction), i.e., the foldable mobile phone 100 forms a left screen and a right screen when being folded, is used for description, which does not constitute a limitation on this application. In another optional embodiment of this application, the foldable mobile phone 100 may be further folded in a transverse direction (i.e., the X-axis direction), i.e., the foldable mobile phone 100 forms an upper screen and a lower screen when being folded. The following content is described by using an example in which the foldable mobile phone 100 is folded in the longitudinal direction.

FIG. 3 is a cross-sectional view of the foldable terminal in FIG. 1 in an AA' direction. As shown in FIG. 2 and FIG. 3, the first body 20 includes a first housing 21 and a first middle frame 22. The second body 30 includes a second housing 31 and a second middle frame 32.

The first housing 21 may be a rear cover (also referred to as a battery cover) of the foldable mobile phone 100, or may be a display (for example, an LCD display, an OLED display, an LED display, among other types) configured for display, which is not limited in the embodiments of this application. The second housing 31 may be a rear cover (also referred to as a battery cover) of the foldable mobile phone, or may be a display configured for display, which is not limited in the embodiments of this application.

The first middle frame 22 includes a first exterior member (a structure of the first middle frame 22 exposed from an outer side) 221 and a first support member 222 fixedly connected to the first exterior member. The first exterior member 221 and the first support member 222 may be integrally formed, or may be separately formed and then fixed together by welding, bonding, or the like. The second middle frame 32 includes a second exterior member (a structure of the second middle frame 32 exposed from an outer side) 321 and a second support member 322 fixedly connected to the second exterior member 321. The second exterior member 321 and the second support member 322 may be integrally formed, or may be separately formed and then fixed together by welding, bonding, or the like.

The first exterior member 221 includes a first outer surface 221a, a first upper side wall 221b, a first inner surface 221c, and a first lower side wall 221d that are sequentially connected. The first upper side wall 221b and the first lower side wall 221d are disposed opposite to each other in the Z-axis direction. The first outer surface 221a and the first inner surface 221c are connected to the first upper side wall 221b and the first lower side wall 221d, and are disposed opposite to each other. The first support member 222 is disposed on the first inner surface 221c, and is located between the flexible display 10 and the first housing 21. The second exterior member 321 includes a second outer surface 321a, a second upper side wall 321b, a second inner surface 321c, and a second lower side wall 321d that are sequentially connected. The second upper side wall 321b and the second lower side wall 321d are disposed opposite to each other in the Z-axis direction. The second outer surface 321a and the second inner surface 321c are connected to the second upper side wall 321b and the second lower side wall 321d, and are disposed opposite to each other. The second support member 222 is disposed on the second inner surface 321c, and is located between the flexible display 10 and the second housing 31.

The flexible display 10, the first inner surface 221c of the first exterior member 221, and the first housing 21 define a first accommodation cavity 23, and the flexible display 10, the second inner surface 321c of the second exterior member 321, and the second housing 31 define a second accommodation cavity 33. Structures (not shown in the figure) such as a printed circuit board, a flexible circuit board, a functional device, and a battery are disposed in the first accommodation cavity 23 and the second accommodation cavity 33. The functional device includes, for example, a display driver module, a camera, or the like. The flexible display 10 and some structures in the accommodation cavities are supported by the first support member 222 of the first middle frame 22 and the second support member 322 of the second middle frame 32.

It should be noted that, related drawings of the rotating shaft structure 40 in the embodiments of this application are simplified schematic diagrams of structures. A specific structure of the rotating shaft structure 40 is not limited in the embodiments of this application, as long as the rotation of the first body 20 and the second body 30 can be implemented to implement a folded state, an unfolded state, or the like of the foldable mobile phone 100. For example, the rotating shaft structure 40 includes structures known to a person skilled in the art, for example, a shaft cover, a synchronization mechanism, two door plates, and a damping mechanism. For specific structures and corresponding relationships, refer to existing technologies. Details are not described herein again.

Still referring to FIG. 2, the foldable mobile phone 100 further includes an attraction structure 60. For example, two attraction structures 60 are provided, and the two attraction structures 60 include a first attraction structure 61 and a second attraction structure 62. The first attraction structure 61 is located in the first accommodation cavity 23, and the second attraction structure 62 is located in the second accommodation cavity 33. When the foldable mobile phone 100 is changed from an unfolded state to a folded state, an attractive force between the first attraction structure 61 and the second attraction structure 62 keeps the foldable mobile phone 100 in a folded state.

For specific types of the first attraction structure 61 and the second attraction structure 62, the specific types of the first attraction structure 61 and the second attraction structure 62 are not limited in the embodiments of this application, as long as the foldable mobile phone 100 is kept in a folded state through the attractive force between the first attraction structure 61 and the second attraction structure 62. For example, the first attraction structure 61 and the second attraction structure 62 are magnetic components.

Still referring to FIG. 2 and FIG. 3, the foldable mobile phone 100 further includes a screen decorating member 50, located on a side of the flexible display 10 away from the bodies, and configured for blocking a gap between the flexible display 10 and the exterior members, that is, configured for blocking a gap between the first inner surface 221c of the first exterior member 221 and an edge of the flexible display 10 and blocking a gap between the second inner surface 321c of the second exterior member 321 and the edge of the flexible display 10.

Because the screen decorating member 50 is exposed from an outer side of the foldable mobile phone 100, the screen decorating member 50 has a large hardness and strength, for example, a hardness greater than or equal to 95°. For a material of the screen decorating member 50, the material of the screen decorating member 50 is not limited in the embodiments of this application, and may be selected by a person skilled in the art according to an actual case. For example, the material of the screen decorating member 50 includes, for example, a thermoplastic polyurethane elastomer (Thermoplastic polyurethanes, TPU), polycarbonate (Polycarbonate, PC), poly(ether-ether-ketone) (poly(ether-ether-ketone), PEEK), and the like. Optionally, carbon fiber or glass fiber with a volume ratio of less than 70% may be mixed in all the foregoing materials to further increase the strength of the screen decorating member 50.

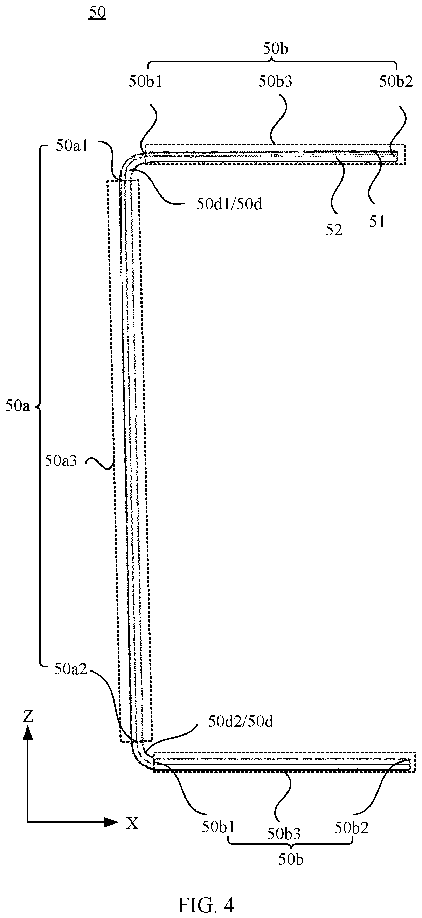

FIG. 4 is a schematic diagram of a front structure of a screen decorating member according to an embodiment of this application. As shown in FIG. 3 and FIG. 4, the screen decorating member 50 has a non-closed annular structure. For example, a shape of the screen decorating member 50 is, for example, a "C" shape, i.e., a shape of a projection of the screen decorating member 50 onto a plane formed by an X axis and a Y axis when the flexible display 10 is in an unfolded state is a "C" shape.

For example, the screen decorating member 50 includes a first decorating section 50a and two second decorating sections 50b. The first decorating section 50a includes a first end portion 50a1, a second end portion 50a2, and a main body portion 50a3 located between the first end portion 50a1 and the second end portion 50a2. The second decorating section 50b includes a first end portion 50b1, a second end portion 50b2, and a main body portion 50b3 located between the first end portion 50b1 and the second end portion 50b2. The two second decorating sections 50b extend in a same direction, for example, both extend in the X-axis direction. An extension direction of the first decorating section 50a is different from an extension direction of the second decorating section 50b. For example, the extension direction of the first decorating section 50a is the Y-axis direction. The two second decorating sections 50b are disposed opposite to each other in the Y-axis direction, and the first decorating section 50a is located between the two second decorating sections 50b. The first end portion 50b1 of one of the second decorating sections 50b is adjacent to the first end portion 50a1 of the first decorating section 50a, and the first end portion 50b1 of the other second decorating section 50b is adjacent to the second end portion 50a2 of the first decorating section 50a. The screen decorating member 50 further includes two bent sections 50d. The two bent sections 50d are respectively a first bent section 50d1 and a second bent section 50d2. The first bent section 50d1 is configured for connecting the first end portion 50a1 of the first decorating section 50a to the first end portion 50b1 of one of the second decorating sections 50b, so that the first decorating section 50a is connected to the second decorating section 50b by a smooth transition. The second bent section 50d2 is configured for connecting the second end portion 50a2 of the first decorating section 50a to the first end portion 50b1 of the other second decorating section 50b, so that the first decorating section 50a is connected to the second decorating section 50b by a smooth transition.

The one second decorating section 50b, the first bent section 50d1, the first decorating section 50a, the second bent section 50d2, and the other second decorating section 50b may be integrally formed, or may be separately formed and then fixedly connected by welding, bonding, or the like.

For example, two screen decorating members 50 are provided, and the two screen decorating members 50 are a first screen decorating member 53 and a second screen decorating member 54. In the Z-axis direction, the first screen decorating member 53 is located on a side of the first upper side wall 221b away from the first lower side wall 221d, and is configured for blocking a gap between the first inner surface 221c of the first exterior member 221 and an edge of the first flat display section 11 of the flexible display 10. In the Z-axis direction, the second screen decorating member 54 is located on a side of the second upper side wall 321b away from the second lower side wall 221d, and the second screen decorating member 54 is configured for blocking a gap between the second inner surface 321c of the second exterior member 321 and an edge of the second flat display section 13 of the flexible display 10. In some embodiments, the first screen decorating member 53 and the second screen decorating member 54 are symmetrically distributed about the axis SO.

For example, each of the first screen decorating member 53 and the second screen decorating member 54 includes a fixing portion 51 and a blocking portion 52. The blocking portion 52 and the fixing portion 51 are both non-closed annular structures, and the fixing portion 51 is disposed around the blocking portion 52. For example, shapes of the blocking portion 52 and the fixing portion 51 are, for example, both "C" shapes. The blocking portion 52 and the fixing portion 51 may be integrally formed and fixedly connected. Certainly, the blocking portion 52 and the fixing portion 51 may alternatively be separately formed and fixed together by welding, bonding, or the like. The fixing portion 51 of the first screen decorating member 53 is configured for fixing the first screen decorating member 53 on the first exterior member 221, so that the blocking portion 52 of the first screen decorating member 53 blocks the gap between the first inner surface 221c of the first exterior member 221 and the edge of the flexible display 10. The fixing portion 51 of the second screen decorating member 54 is configured for fixing the second screen decorating member 54 on the second exterior member 321, so that the blocking portion 52 of the second screen decorating member 54 blocks the gap between the second inner surface 321c of the second exterior member 321 and the edge of the flexible display 10.

In the Z-axis direction, each of the first screen decorating member 53 and the second screen decorating member 54 includes a first decorating surface 50f and a second decorating surface 50g that are opposite to each other. The first decorating surface 50f of the first screen decorating member 53 is located on a side of the second decorating surface 50g away from the first upper side wall 221b of the first exterior member 221, and the first decorating surface 50f of the second screen decorating member 54 is located on a side of the second decorating surface 50g away from the first upper side wall 221b of the second exterior member 321.

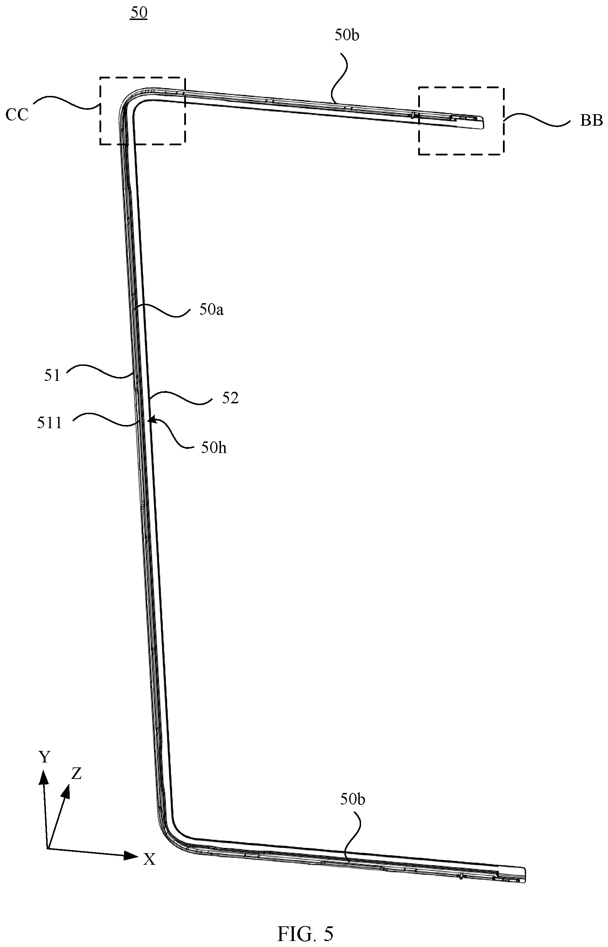

FIG. 5 is a schematic diagram of a rear structure of a screen decorating member according to an embodiment of this application. As shown in FIG. 3 and FIG. 5, the second decorating surface 50g of the screen decorating member 50 is locally recessed toward the edge of the flexible display 10 in the Z-axis direction to form a non-closed annular notch 50h. A part of the screen decorating member 50 corresponding to the annular notch 50h is the blocking portion 52. To be specific, in the Z-axis direction, an orthographic projection of the annular notch 50h onto the plane formed by the X axis and the Y axis coincides with an orthographic projection of the blocking portion 52 onto the plane formed by the X axis and the Y axis, and another part of the screen decorating member 50 other than the blocking portion 52 is the fixing portion 51. The annular notch 50h is provided, so that a thickness of the blocking portion 52 is less than a thickness of the fixing portion 51 in the Z-axis direction. In this way, the edge of the flexible display 10 may extend into the annular notch 50h, to block a gap between the edge of the flexible display 10 and an inner surface of an exterior member by using the blocking portion 52, and protect the edge of the flexible display 10.

Still referring to FIG. 3 and FIG. 5, in some embodiments, the second decorating surface 50g of the fixing portion 51 locally protrudes in the Z-axis direction to form at least one protruding portion 511. Correspondingly, a side wall of the exterior member is locally recessed to form a recessed portion matching the protruding portion 511. The protruding portion 511 is embedded in the recessed portion, so that the fixing portion 51 of the screen decorating member 50 is fixed on the exterior member. For example, the first upper side wall 221b of the first exterior member 221 is locally recessed to form a recessed portion matching the protruding portion 511 corresponding to the fixing portion 51 of the first screen decorating member 53. The protruding portion 511 is embedded in the recessed portion, so that the fixing portion 51 of the first screen decorating member 53 is fixed to the first exterior member 221. For example, the fixing portion 51 may be fixed to the first exterior member 221 by an interference fit between the protruding portion 511 and the recessed portion, or the fixing portion 51 of the first screen decorating member 53 may be fixed to the first exterior member 221 by bonding (glue or another viscous material). Similarly, the second upper side wall 321b of the second exterior member 321 is locally recessed to form a recessed portion matching the protruding portion 511 corresponding to the fixing portion 51 of the second screen decorating member 54. The protruding portion 511 is embedded in the recessed portion, so that the fixing portion 51 of the second screen decorating member 54 is fixed to the second exterior member 321. For example, the fixing portion 51 may be fixed to the second exterior member 321 by an interference fit between the protruding portion 511 and the recessed portion, or the fixing portion 51 of the second screen decorating member 54 may be fixed to the second exterior member 321 by bonding (glue or another viscous material).

It should be noted that one protruding portion 511 may be provided, and the protruding portion 511 may be a semi-closed annular protruding portion 511. Certainly, a plurality of protruding portions 511 may be provided, and the plurality of protruding portions 511 may be evenly distributed on the second decorating surface 50g, so that the fixing portion 51 of the screen decorating member 50 is fixed to the exterior member more stably.

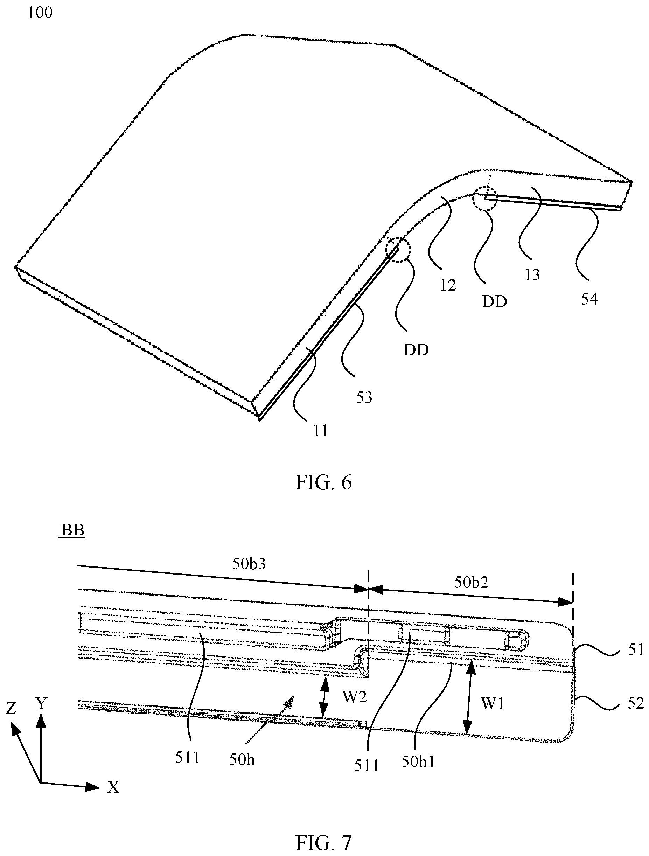

It is found through research that FIG. 6 is a schematic diagram of a structure of a foldable terminal in a folded state according to an embodiment of this application. As shown in FIG. 1, FIG. 4, and FIG. 6, the first screen decorating member 53 only blocks the gap between the first inner surface 221c of the first exterior member 221 and the edge of the first flat display section 11 of the flexible display 10, and the second screen decorating member 54 only blocks the gap between the second inner surface 321c of the second exterior member 321 and the edge of the second flat display section 13 of the flexible display 10, and does not block an edge of the bent display section 12 of the flexible display 10. Therefore, during folding, a position (for example, a DD region in FIG. 1 and FIG. 6) of the second end portion 50b2 of the second decorating section 50b of the first screen decorating member 53 may come into contact with the bent display section 12 of the flexible display 10. When the foldable mobile phone 100 falls in a folded state (the angle between the plane in which the first flat display section 11 is located and the plane in which the second flat display section 13 is located is greater than or equal to 0° and less than 180°), the foldable mobile phone 100 is subjected to an impact force of the ground or another object. Under the action of the impact force, the flexible display 10 and the screen decorating member 50 displace and/or vibrate, so that the flexible display 10 is in contact with the screen decorating member 50. An area of the second end portion 50b2 is small. Therefore, when the second end portion 50b2 is in contact with the flexible display 10, pressure increases, and as a result a position of the second end portion 50b2 of the second decorating section 50b of the screen decorating member 50 (for example, a position of a sharp corner of the blocking portion 52) may puncture the bent display section 12 of the flexible display 10 to cause damage to the flexible display 10. In addition, when the foldable mobile phone 100 falls in an unfolded state, under the action of an impact force, the flexible display 10 and the screen decorating member 50 displace and/or vibrate. The fixing portion 51 at the first bent section 50d1, the fixing portion 51 at the second bent section 50d2 of the first screen decorating member 53, the fixing portion 51 at the first bent section 50d1, and the fixing portion 51 at the second bent section 50d2 of the second screen decorating member 54 may collide with four corners (for example, EE regions in FIG. 1) of the flexible display 10, resulting in damage to the flexible display 10.

When the foldable mobile phone 100 falls in a folded state, to keep the second end portion 50b2 of the second decorating section 50b from puncturing the bent display section 12 of the flexible display 10 to avoid causing damage to the flexible display 10,

In an example, FIG. 7 is an enlarged view of a BB region of the screen decorating member in FIG. 5 according to an embodiment of this application. As shown in FIG. 5 and FIG. 7, in the second decorating section 50b, a width W1 of the notch 50h located at the second end portion 50b2 is greater than a width W2 of the notch 50h located at the main body portion 50b3. To be specific, a size of the notch 50h of the second end portion 50b2 is increased, i.e., a width of the fixing portion 51 of the second end portion 50b2 is reduced.

With such an arrangement, strength of the second end portion 50b2 can be reduced. The second end portion 50b2 with reduced strength releases partial stress after impacting the bent display section 12 of the flexible display 10, thereby achieving the objective of protecting the flexible display 10. In addition, because only the size of the notch 50h is increased, the appearance effect of the second end portion 50b2 is not affected, the structure is simple, the process steps are simple, and the costs are low.

It should be noted that, a width of the notch 50h is a size of the notch 50h in a direction (also referred to as a second direction) of the fixing portion 51 pointing to the blocking portion 52. The following embodiments are the same, and details are not described below again.

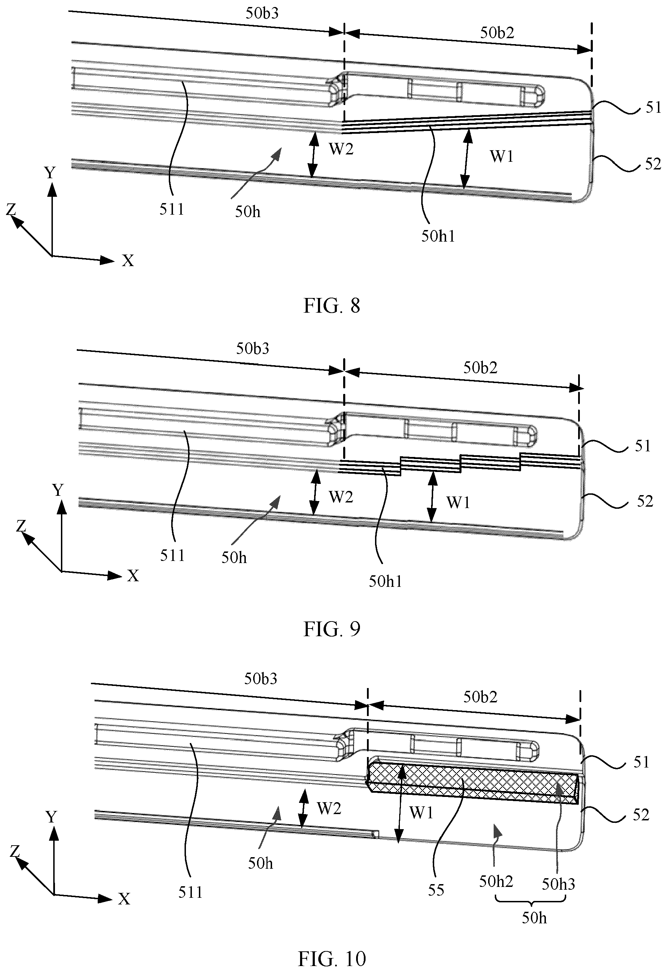

In this case, FIG. 8 is a schematic diagram of a partial structure of a screen decorating member according to an embodiment of this application. As shown in FIG. 8, in the second end portion 50b2, the width of the notch 50h decrements on a gradient in a direction (also referred to as a third direction) of the second end portion 50b2 pointing to the main body portion 50b3. With such an arrangement, while the overall strength of the screen decorating member 50 is ensured, the second end portion 50b2 can further release partial stress after impacting the bent display section 12 of the flexible display 10, thereby protecting the flexible display 10.

It should be noted that, as shown in FIG. 8, that the width of the notch 50h decrements on a gradient may be that a side wall 50h1 (i.e., a side wall of the fixing portion 51 protruding from the blocking portion 52) of the notch 50h is an inclined surface. FIG. 9 is a schematic diagram of a partial structure of a screen decorating member according to an embodiment of this application. As shown in FIG. 9, the side wall 50h1 of the notch 50h may alternatively be a stepped surface.

As can be learned from the foregoing content, in some embodiments, the second decorating surface 50g of the fixing portion 51 locally protrudes in the Z-axis direction to form at least one protruding portion 511. Correspondingly, a side wall of the exterior member is locally recessed to form a recessed portion matching the protruding portion 511. The protruding portion 511 is embedded in the recessed portion, so that the fixing portion 51 of the screen decorating member 50 is fixed on the exterior member. To avoid some structures (for example, a shaft cover) of the rotating shaft structure 40, still referring to FIG. 7, a size (i.e., a thickness) of the protruding portion 511 at the second end portion 50b2 in the Z-axis direction is less than a size (i.e., a thickness) of the protruding portion 511 at the main body portion 50b3 in the Z-axis direction. The following accompanying drawings are also described by using an example in which the size of the protruding portion 511 at the second end portion 50b2 in the Z-axis direction is less than the size of the protruding portion 511 at the main body portion 50b3 in the Z-axis direction.

In another example, FIG. 10 is a schematic diagram of a partial structure of another screen decorating member according to an embodiment of this application. As shown in FIG. 10, in the second decorating section 50b, the width W1 of the notch 50h (also referred to as a first notch) located at the second end portion 50b2 is greater than the width W2 of the notch 50h (also referred to as a second notch) located at the main body portion 50b3. The notch 50h of the second end portion 50b2 includes a first part 50h2 and a second part 50h3. The first part 50h2 is a portion with a same width as the notch 50h of the main body portion 50b3, and the second part 50h3 is a remaining part of the notch 50h of the second end portion 50b2 other than the first part 50h2. A soft structure 55 is disposed at the second part 50h3 of the second end portion 50b2. To be specific, the soft structure 55 is disposed in a part of the notch in the notch 50h of the second end portion 50b2 that has a larger width than the width W2 of the notch 50h of the main body portion 50b3.

A hardness of the soft structure 55 is less than a hardness of the screen decorating member 50. For example, the hardness of the soft structure 55 is greater than or equal to 60° and less than or equal to 65°. For a material of the soft structure 55, the material of the soft structure 55 is not limited in the embodiments of this application, may be selected by a person skilled in the art according to an actual case, and may be, for example, plastic, soft glue, or the like.

The soft structure 55 is disposed at the second part 50h3 of the second end portion 50b2, i.e., the width of the fixing portion 51 is still an equal-width design (only a material in a partial region at the second end portion 50b2 is different). With such an arrangement, a common material is still kept at the appearance of the screen decorating member 50 to keep the appearance effect and the overall strength of the screen decorating member 50. In addition, when the foldable mobile phone 100 falls in a folded state, the soft structure 55 has an instantaneous deformation to release stress, thereby achieving the objective of protecting the flexible display 10.

It should be noted that, the width of the notch 50h is a size of the notch 50h in the direction of the fixing portion 51 pointing to the blocking portion 52. The width of the fixing portion 51 is a size of the fixing portion 51 in the direction of the fixing portion 51 pointing to the blocking portion 52.

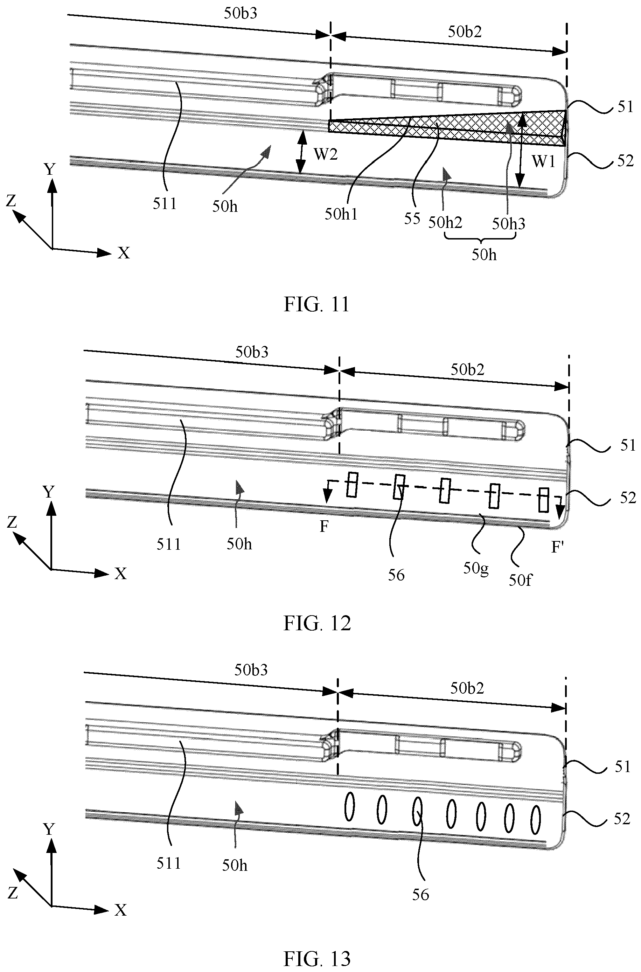

It can be learned from the foregoing example that, in the second end portion 50b2, the width of the notch 50h decrements on a gradient of the second end portion 50b2 pointing to the main body portion 50b3 (as shown in FIG. 8 and FIG. 9). Therefore, when the soft structure 55 is disposed, a width W3 thereof may gradually increment on a gradient. For example, FIG. 11 is a schematic diagram of a partial structure of another screen decorating member according to an embodiment of this application. As shown in FIG. 11, the width W3 of the soft structure 55 decrementing on a gradient may be that a surface of the soft structure 55 in contact with the side wall 50h1 of the notch 50h is an inclined surface. It should be noted that, in FIG. 10, an example in which the surface of the soft structure 55 in contact with the side wall 50h1 of the notch 50h is an inclined surface is used for description, but does not constitute a limitation on this application. In another optional embodiment of this application, the surface of the soft structure 55 in contact with the side wall 50h1 of the notch 50h may alternatively be a stepped surface (not shown in the figure). With such an arrangement, while the overall strength of the screen decorating member 50 is ensured, the second end portion 50b2 can further release partial stress through the soft structure 55 after impacting the bent display section 12 of the flexible display 10, thereby protecting the flexible display 10.

In still another example, FIG. 12 is a schematic diagram of a partial structure of another screen decorating member according to an embodiment of this application. As shown in FIG. 12, the blocking portion 52 includes a blocking surface facing the flexible display 10. The blocking surface and the side wall of the fixing portion 51 protruding from the blocking portion 52 define the notch 50h, and at least one groove is opened in the blocking surface at the second end portion 50b2.

With such an arrangement, the strength of the second end portion 50b2 can be reduced. The second end portion 50b2 with reduced strength releases partial stress through the groove 56 after impacting the bent display section 12 of the flexible display 10, thereby achieving the objective of protecting the flexible display 10. In addition, an opening of the groove 56 is located at the second decorating surface 50g instead of being located at the first decorating surface 50h. Therefore, the appearance effect of the second end portion 50b2 is not affected, the structure is simple, the process steps are simple, and the costs are low.

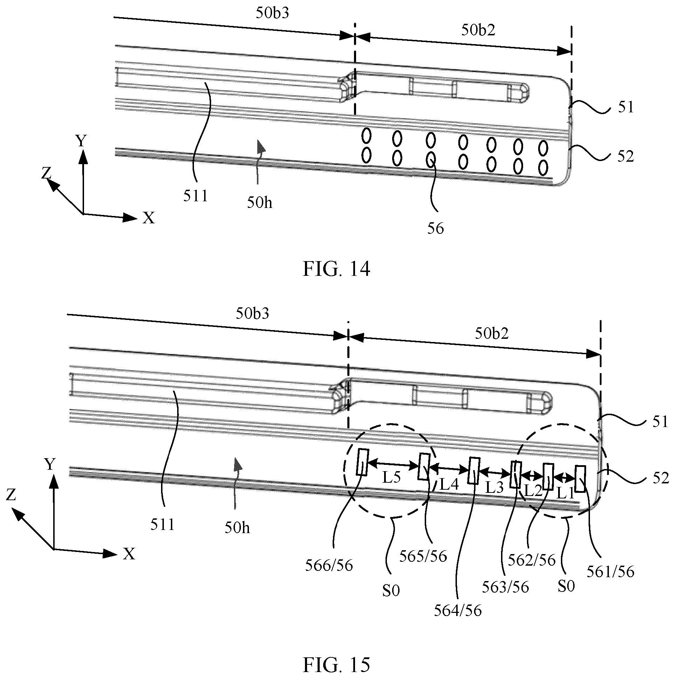

It should be noted that, in the embodiments of this application, a shape and a quantity of the grooves 56 are not limited, and may be set by a person skilled in the art according to an actual case. In the foregoing example, only an example in which each of orthographic projections of five grooves 56 onto the plane formed by the X axis and the Y axis has a rectangular shape as an example for description. In another optional embodiment, FIG. 13 is a schematic diagram of a partial structure of another screen decorating member according to an embodiment of this application. As shown in FIG. 13, the shape of the orthographic projection of the groove 56 onto the plane formed by the X axis and the Y axis may alternatively be an elliptical shape, a circular shape (not shown in the figure), a square shape (not shown in the figure), a triangular shape (not shown in the figure), or the like. When the shape of the orthographic projection of the groove 56 onto the plane formed by the X axis and the Y axis is an elliptical shape, a circular shape, or the like, the groove 56 can be kept from being damaged due to stress concentration at corners of the groove, to avoid causing damage to the blocking portion 52. In addition, the foregoing examples are all described by using an example in which one row (parallel to the direction of the second end portion 50b2 pointing to the main body portion 50b3) of grooves 56 are provided. In another optional embodiment, FIG. 14 is a schematic diagram of a partial structure of another screen decorating member according to an embodiment of this application. As shown in FIG. 14, a plurality of rows of grooves 56 may alternatively be provided. In the following content, an example in which the shape of the orthographic projection of the groove 56 onto the plane formed by the X axis and the Y axis is a rectangular shape and one row of grooves 56 are provided is used for description, and a quantity of the grooves 56 in the following example is also merely an example.

In this case, to maximally keep the strength of the screen decorating member 50, FIG. 15 is a schematic diagram of a partial structure of another screen decorating member according to an embodiment of this application. As shown in FIG. 15, in the direction of the second end portion 50b2 pointing to the main body portion 50b3, a volume of the groove 56 in the second end portion 50b2 gradually decreases in a unit area of the blocking surface. The unit area of the blocking surface is an area parallel to the plane formed by the X axis and the Y axis. As shown in FIG. 15, for example, a volume of the groove 56 in a unit area SO of the blocking surface at an edge of the second end portion 50b2 away from the main body portion 50b3 is greater than a total volume of the groove 56 in the unit area SO of the blocking surface at an edge of the second end portion 50b2 in contact with the main body portion 50b3.

The volume of the groove 56 is a sum of adding of volumes of all the grooves 56 in the unit area of the blocking surface. For example, when one groove 56 is provided in the unit area of the blocking surface, a volume of the groove 56 is a volume of the groove 56. When a plurality of grooves 56 are provided in the unit area of the blocking surface, a volume of the grooves 56 is a sum of volumes of the grooves 56.

In the direction of the second end portion 50b2 pointing to the main body portion 50b3, a volume of the groove 56 in the second end portion 50b2 gradually decreases in a unit area of the blocking surface in a plurality of manners. Several feasible manners are described below. The following description does not constitute a limitation on this application.

In a possible implementation, still referring to FIG. 15, a plurality of grooves 56 are provided. A distance between two adjacent grooves 56 gradually increases in the direction of the second end portion 50b2 pointing to the main body portion 50b3.

For example, six grooves 56 are provided, and the six grooves 56 include a first groove 561, a second groove 562, a third groove 563, a fourth groove 564, a fifth groove 565, and a sixth groove 566. A distance between the first groove 561 and the second groove 562 is L1, a distance between the second groove 562 and the third groove 563 is L2, a distance between the third groove 563 and the fourth groove 564 is L3, a distance between the fourth groove 564 and the fifth groove 565 is L4, a distance between the fifth groove 565 and the sixth groove 566 is L5, and L5 > L4 > L3 > L2 > L1.

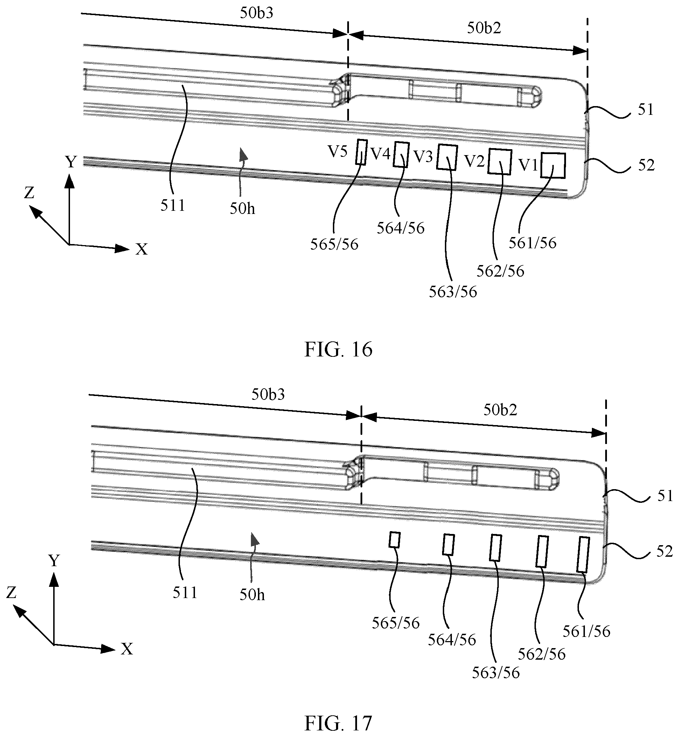

In another possible implementation, FIG. 16 is a schematic diagram of a partial structure of another screen decorating member according to an embodiment of this application. As shown in FIG. 16, a plurality of grooves 56 are provided. Volumes of the plurality of grooves 56 gradually decrease in the direction of the second end portion 50b2 pointing to the main body portion 50b3.

For example, five grooves 56 are provided. The five grooves 56 include a first groove 561, a second groove 562, a third groove 563, a fourth groove 564, and a fifth groove 565. A volume of the first groove 561 is V1, a volume of the second groove 562 is V2, a volume of the third groove 563 is V3, a volume of the fourth groove 564 is V4, a volume of the fifth groove 565 is V5, and V1 > V2 > V3 > V4 > V5.

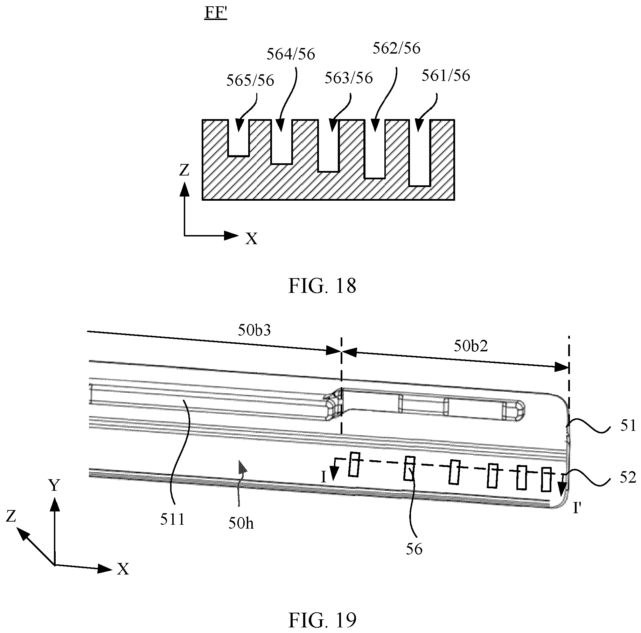

In this case, lengths (as shown in FIG. 16), widths (as shown in FIG. 17), and/or depths (as shown in FIG. 18) of the first groove 561, the second groove 562, the third groove 563, the fourth groove 564, and the fifth groove 565 may gradually decrease, so that the volumes of the plurality of grooves 56 gradually decrease in the direction of the second end portion 50b2 pointing to the main body portion 50b3.

It should be noted that a length of the groove 56 is a size of the groove 56 in the direction (i.e., the X-axis direction shown in FIG. 15) of the second end portion 50b2 pointing to the main body portion 50b3. A width of the groove 56 is a size of the groove 56 in the direction (i.e., the Y-axis direction shown in FIG. 15) of the fixing portion 51 pointing to the blocking portion 52. A depth of the groove 56 is a size of the groove 56 in the Z-axis direction shown in FIG. 15.

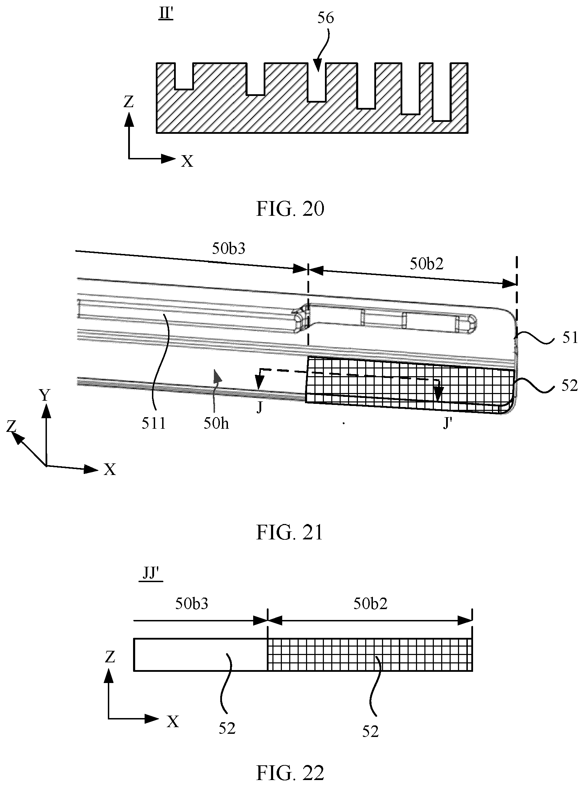

In other words, for the grooves 56, the density gradually changes and the sizes gradually changes separately, so that in the direction of the second end portion 50b2 pointing to the main body portion 50b3, the total volume of the groove 56 in the second end portion 50b2 gradually changes in a unit area of the blocking surface. Certainly, the density of the grooves 56 may gradually change and at the same time the sizes of the grooves 56 also gradually change, so that in the direction of the second end portion 50b2 pointing to the main body portion 50b3, the total volume of the groove 56 in the second end portion 50b2 gradually changes in a unit area of the blocking surface. For example, FIG. 19 is a schematic diagram of a partial structure of another screen decorating member according to an embodiment of this application. FIG. 20 is a cross-sectional view of the screen decorating member in FIG. 19 in an II' direction. As shown in FIG. 19 and FIG. 20, the distance between two adjacent grooves 56 gradually increases in the direction of the second end portion 50b2 pointing to the main body portion 50b3, and the depths of the plurality of grooves 56 gradually decrease.

In still another example, FIG. 21 is a schematic diagram of a partial structure of another screen decorating member according to an embodiment of this application.

FIG. 22 is a cross-sectional view of the screen decorating member in FIG. 21 in a JJ' direction. As shown in FIG. 21 and FIG. 22, in the second decorating section 50b, a hardness of a material of the blocking portion 52 at the second end portion 50b2 is less than a hardness of a material of the blocking portion 52 at the main body portion 50b3. For example, the material of the blocking portion 52 at the second end portion 50b2 is different from the material of the blocking portion 52 at the main body portion 50b3. For example, the material of the blocking portion 52 at the second end portion 50b2 is, for example, rubber, which may be specifically referred to as, for example, a thermoplastic polyurethane elastomer (Thermoplastic polyurethanes, TPU).

Because the blocking portion 52 at the second end portion 50b2 is soft, when the foldable mobile phone 100 falls in a folded state, the soft blocking portion 52 has an instantaneous deformation under the action of impact to release stress, thereby achieving the objective of protecting the flexible display 10.

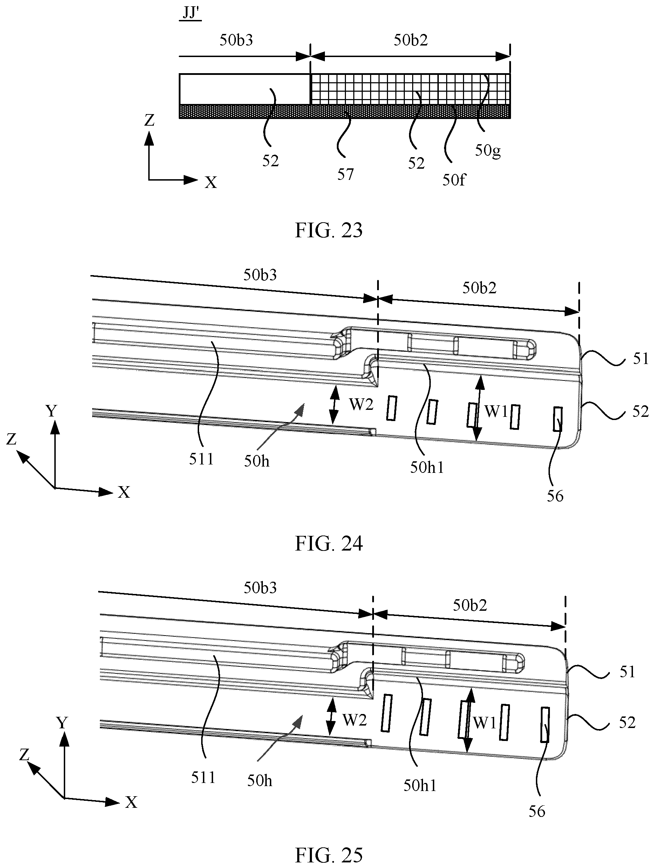

In this case, it is considered that, when the materials are different, the colors of different regions of the screen decorating member 50 may be different. Even if the colors are the same, due to splicing, seam or joint traces may exist, affecting the appearance of the screen decorating member 50. Therefore, FIG. 23 is another cross-sectional view of the screen decorating member in FIG. 21 in a JJ' direction. As shown in FIG. 23, a protective layer 57 is disposed on the first decorating surface 50f of the screen decorating member 50. The protective layer 57 blocks the entire first decorating surface 50f of the screen decorating member 50, to block a gap or seam trace at a connection between the blocking portion 52 of the second end portion 50b2 and the blocking portion 52 of the main body portion 50b3 caused by splicing, so that the screen decorating member 50 has a consistent appearance.

A specific structure of the second end portion 52b2 is described above. A soft material is disposed (i.e., a change in material) or a groove is provided (i.e., a change in structure) at the second end portion 52b to implement the protection of the bent display section 12 of the flexible display 10, to avoid a case that when the foldable mobile phone 100 falls in a folded state, the second end portion 50b2 of the second decorating section 50b of the screen decorating member 50 punctures the bent display section 12 of the flexible display 10 under the action of impact, causing damage to the flexible display 10.

It should be noted that the foregoing four examples may be combined with each other without causing contradictions. For example, FIG. 24 is a schematic diagram of a partial structure of another screen decorating member according to an embodiment of this application. As shown in FIG. 24, in the second decorating section 50b, the width W1 of the notch 50h located at the second end portion 50b2 is greater than the width W2 of the notch 50h located at the main body portion 50b3, and at least one groove 56 is opened in the blocking portion 52 located at the second end portion 50b2.

It may be understood that, when the width of the notch 50h located at the second end portion 50b2 increases, the width of the groove 56 may alternatively extend, i.e., extend into a part of the notch in the notch 50h of the second end portion 50b2 that has a larger width than the width W2 of the notch 50h of the main body portion 50b3, as shown in FIG. 25.

It should be noted that the length of the second end portion 52b2 in the X-axis direction is not limited in the embodiments of this application, and may be set by a person skilled in the art according to an actual case. For example, in the X-axis direction, the length of the second end portion 52b2 is greater than or equal to 0.5 mm and less than or equal to 10 mm. In this way, the overall strength of the screen decorating member 50 is not affected due to an excessively large length of the second end portion 52b2, and the effect of stress release is kept from failing due to an excessively small length of the second end portion 52b2. Therefore, in the embodiments of this application, the length of the second end portion 52b is set between 0.5 mm and 10 mm, so that while good strength is ensured, stress can be released, to avoid a case that when the foldable mobile phone 100 falls in a folded state, the second end portion 50b2 of the second decorating section 50b of the screen decorating member 50 punctures the bent display section 12 of the flexible display 10 under the action of impact to cause damage to the flexible display 10.

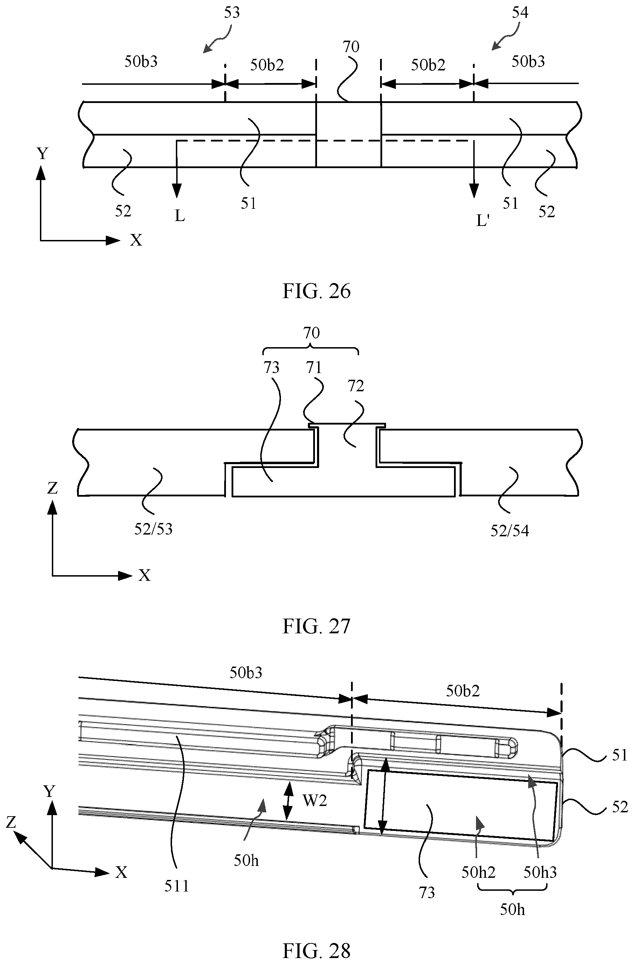

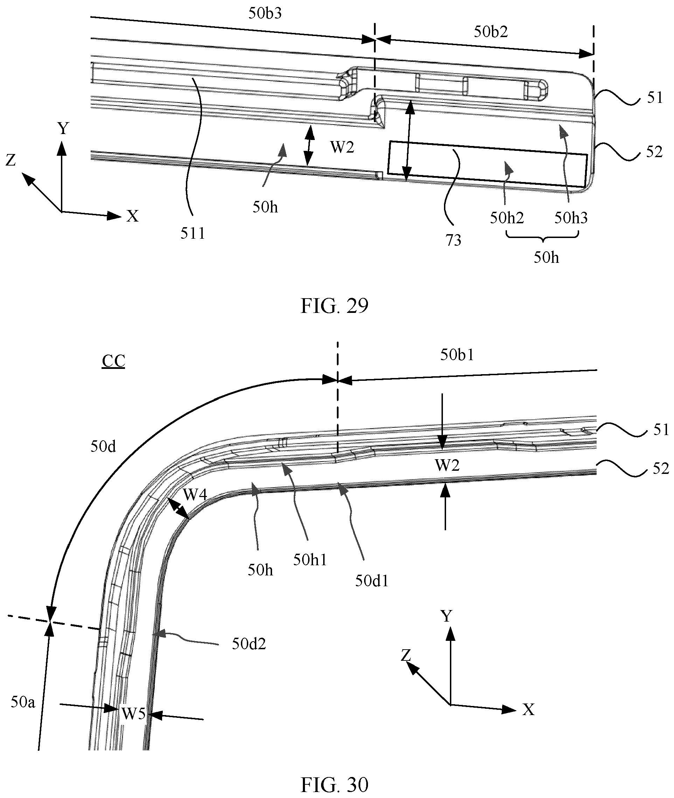

It should be further noted that, as can be learned from the foregoing content, the first screen decorating member 53 only blocks the gap between the first inner surface 221c of the first exterior member 221 and the edge of the first flat display section 11 of the flexible display 10, and the second screen decorating member 54 only blocks the gap between the second inner surface 321c of the second exterior member 321 and the edge of the second flat display section 13 of the flexible display 10, and does not block the edge of the bent display section 12 of the flexible display 10 (i.e., a gap exists between the second end portion 50b2 of the second decorating section 50b of the first screen decorating member 53 and the second end portion 50b2 of the second decorating section 50b of the second screen decorating member 54 in the X-axis direction), affecting the appearance. To improve the appearance effect of the foldable mobile phone 100, in some embodiments, FIG. 26 is a diagram of a position relationship among a first screen decorating member, a second screen decorating member, and a blocking member according to an embodiment of this application. FIG. 27 is a cross-sectional view of the first screen decorating member, the second screen decorating member, and the blocking member in FIG. 26 in an LL' direction. As shown in FIG. 26 and FIG. 27, to block the edge of a bent portion, in the X-axis direction, a blocking member 70 is disposed between the second end portion 50b2 of the second decorating section 50b in the first screen decorating member 53 and the second end portion 50b2 of the second decorating section 50b in the second screen decorating member 54 in the X-axis direction. In the Z-axis direction, the blocking member 70 includes a first section 71, a second section 73, and a third section 72 connecting the first section 71 and the second section 73. FIG. 28 is a schematic diagram of a partial structure of a screen decorating member and a blocking member according to an embodiment of this application. As shown in FIG. 28, in the Z-axis direction, the third section 72 is located, for example, at the notch 50h of the second end portion 50b2. To be specific, in the Z-axis direction, the blocking portion 52, the edge of the flexible display 10, and the third section 72 are sequentially disposed in the Z-axis direction. The third section 72 may be located only in the first part 50h2 (as shown in FIG. 29). The first part 50h2 is a part of the notch 50h of the second end portion 50b2 having a same width as the notch 50h of the main body portion 50b3 (as shown in FIG. 7), or may be located at the first part 50h2 and the second part 50h3 (as shown in FIG. 28). The second part 50h3 is a remaining part of the notch 50h of the second end portion 50b2 other than the first part 50h2 (as shown in FIG. 7). It may be understood that, when the third section 72 is located at the first part 50h2 and the second part 50h3 (shown in FIG. 28), to further reduce the strength of the second end portion 50b2, a width of the second part 50h3 may be further increased to meet a requirement of reducing the strength of the second end portion 50b2 when the foldable terminal includes the blocking member 70 and the third section 72 is located at the first part 50h2 and the second part 50h3. Correspondingly, if the soft structure 55 is disposed in the second part 50h3, a width of the soft structure 55 is also correspondingly reduced (i.e., the soft structure does not fill up the entire second part 50h3), to avoid the third section 72 of the blocking member 70.

When the foldable mobile phone 100 falls in an unfolded state, to keep the bent section 50d from colliding with an edge of the flexible display 10 to avoid causing damage to the flexible display 10,

In an example, FIG. 30 is a partial enlarged view of a CC region in the screen decorating member in FIG. 5. As shown in FIG. 30, a width W4 of the notch 50h located at the bent section 50d is greater than a width W2 of the notch 50h located at the first end portion 50b1 and a width W5 of the notch 50h located at the first decorating section 50a. To be specific, the size of the notch 50h at the bent section 50d increases, i.e., the width of the fixing portion 51 at the bent section 50d decreases. The width W2 of the notch 50h located at the first end portion 50b1 is, for example, the same as the width W5 of the notch 50h located at the first decorating section 50a.

With such an arrangement, a case that when the foldable mobile phone 100 falls in an unfolded state, a corner position of the flexible display 10 collides with the fixing portion 51 located at the bent section 50d under the action of impact to cause damage to the flexible display 10 can be avoided. In addition, because the size of the notch 50h is increased, the structure is simple, the process steps are simple, and the costs are low.

In this case, still referring to FIG. 25, the bent section 50d includes a first edge 50d1 and a second edge 50d2, the first edge 50d1 is in contact with the first end portion 50b1 of the second decorating member 50b, and the second edge 50d2 is in contact with the first decorating member 50a. The width of the notch 50h gradually decreases from a preset position of the bent section 50d to the first edge 50d1 thereof, the width of the notch 50h gradually decreases from the preset position of the bent section 50d to the second edge 50d2, and the side wall 50h1 (i.e., the side wall of the fixing portion 51 at the bent section 50d) of the notch 50h is a smooth curved surface. A specific position of the preset position in the bent section 50d is not limited in the embodiments of this application, and may be set by a person skilled in the art according to an actual case. For example, the preset position is a position that is in the bent section 50d and that has a distance to the first edge 50d1 equal to a distance to the second edge 50d2. Alternatively, the preset position is a position that is in the bent section 50d and that has a distance to the first edge 50d1 greater than a distance to the second edge 50d2. Alternatively, the preset position is a position that is in the bent section 50d and that has a distance to the first edge 50d1 less than a distance to the second edge 50d2. In the embodiments of this application, the preset position is the position that is in the bent section 50d and that has the distance to the first edge 50d1 equal to the distance to the second edge 50d2.

In the bent section 50d, when the width of the notch 50h gradually decreases from the preset position to the edge (the first edge 50d1 or the second edge 50d2), a case that when the foldable mobile phone 100 falls in an unfolded state, a corner position of the flexible display 10 collides with the fixing portion 51 located at the bent section 50d to cause damage to the flexible display 10 can be avoided, and the overall strength of the screen decorating member 50 can be ensured.

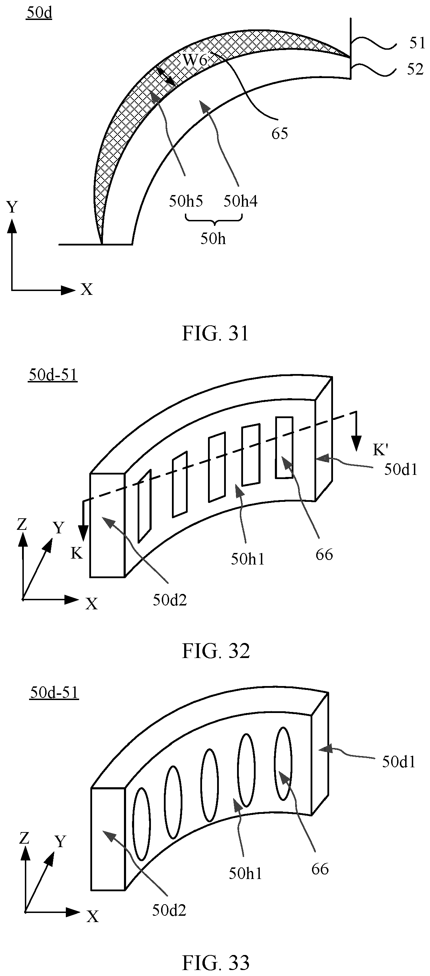

In another example, FIG. 31 is a schematic top view of a structure of a bent section according to an embodiment of this application. As shown in FIG. 31, the width W4 of the notch 50h located at the bent section 50d is greater than the width W2 of the notch 50h located at the first end portion 50b1 and the width W5 of the notch 50h located at the first decorating section 50a. The notch 50h (also referred to as a third notch) of the bent section 50d includes a third part 50h4 and a fourth part 50h5. The third part 50h4 is a part having a same width as the notch 50h (also referred to as a fourth notch) of the first end portion 50b1 and/or having a same width as the notch 50h (also referred to as a fifth notch) of the first decorating section 50a. The fourth part 50h5 is a remaining part other than the third part 50h4 in the notch 50h of the bent section 50d. A soft structure 65 is disposed at the fourth part 50h5. To be specific, in the notch 50h of the bent section 50d, the soft structure 65 is disposed in the part of notch having a larger width than the notch 50h of the first end portion 50b1 and/or having a larger width than the notch 50h of the first decorating section 50a.

A hardness and a material of the soft structure 65 are the same as those in the foregoing examples. For details, refer to the foregoing examples, and details are not described herein again.

The soft structure 65 is disposed at the fourth part 50h5, i.e., the width of the fixing portion 51 at the bent section 50d is still an equal-width design (only a material in a partial region is different). With such an arrangement, the overall strength of the screen decorating member 50 can be kept. In addition, when the foldable mobile phone 100 falls in an unfolded state, the soft structure 65 has an instantaneous deformation to release stress, thereby achieving the objective of protecting the edge of the flexible display 10.

It can be learned from the foregoing example that, the width of the notch 50h gradually decreases from the preset position of the bent section 50d to the first edge 50d1 thereof, and the width of the notch 50h gradually decreases from the preset position of the bent section 50d to the second edge 50d2 (as shown in FIG. 30). Therefore, when the soft structure 65 is disposed, a width W6 of the soft structure 65 gradually decreases from the preset position of the bent section 50d to the second edge 50d2, and the width W6 of the soft structure 65 gradually decreases from the preset position of the bent section 50d to the first edge 50d1. For example, a shape of a projection of the soft structure 65 onto the plane formed by the X axis and the Y axis is, for example, a "crescent" shape.

In still another example, FIG. 32 is a schematic diagram of a structure of a fixing portion at a bent section according to an embodiment of this application, specifically, a part of the fixing portion 51 higher than the blocking portion 52 (in the Z-axis direction) at the bent section 50d. As shown in FIG. 32, in the bent section 50d, at least one groove 66 is opened in a side wall (i.e., the side wall 50h1 of the notch 50h) of the fixing portion 51. The groove 66 is a structure formed by the side wall 50h1 being locally recessed in a direction of the blocking portion 52 pointing to the fixing portion 51.

With the arrangement of the groove 66, strength of the fixing portion 51 at the bent section 50d can be reduced. The fixing portion 51 with reduced strength releases partial stress through the groove 66 after impacting a corner of the flexible display 10, thereby achieving the objective of protecting the flexible display 10. In addition, the structure is simple, the process steps are simple, and the costs are low.

It should be noted that, in the embodiments of this application, a shape and a quantity of the grooves 66 are not limited, and may be set by a person skilled in the art according to an actual case. In the foregoing example, only an example in which each of orthographic projections of five grooves 66 onto a reference plane (a plane perpendicular to the direction of the blocking portion 52 pointing to the fixing portion 51) has a rectangular shape as an example for description. In another optional embodiment, FIG. 33 is a schematic diagram of a structure of another fixing portion at a bent section according to an embodiment of this application. As shown in FIG. 33, the shape of the orthographic projection of the groove 66 onto the plane formed by the X axis and the Y axis may alternatively be an elliptical shape, a circular shape (not shown in the figure), a square shape (not shown in the figure), a triangular shape (not shown in the figure), or the like. When the shape of the orthographic projection of the groove 66 onto the plane formed by the X axis and the Y axis is an elliptical shape, a circular shape, or the like, the groove 66 can be kept from being damaged due to stress concentration at corners of the groove 66, to avoid causing damage to the fixing portion 51. In addition, the foregoing examples are all described by using an example in which one row (parallel to a direction of the preset position of the bent section 50d pointing to the first edge 50d1) of grooves 66 are provided. In another optional embodiment, a plurality of rows of grooves 66 (not shown in the figure) may alternatively be provided. In the following content, an example in which the shape of the orthographic projection of the groove 66 onto the reference plane is a rectangular shape and one row of grooves 56 are provided is used for description, and a quantity of the grooves 66 in the following example is also merely an example.

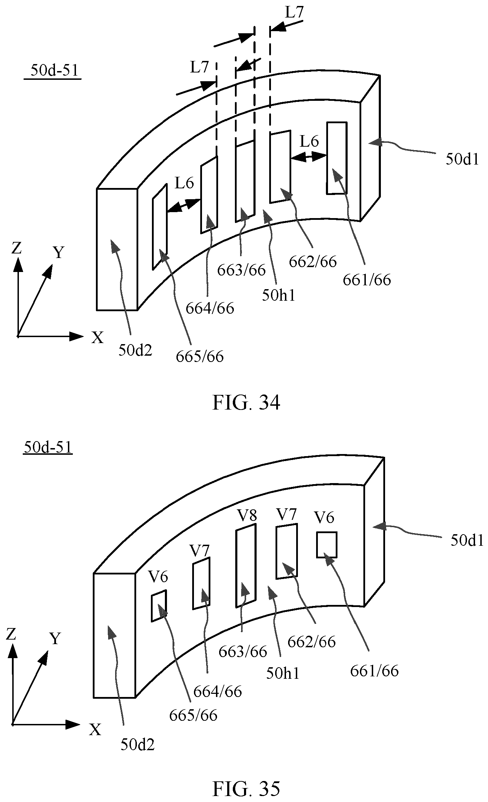

In this case, to maximally keep the strength of the screen decorating member 50, FIG. 34 is a schematic diagram of a structure of another fixing portion at a bent section according to an embodiment of this application. As shown in FIG. 34, the total volume of the grooves 66 gradually decreases in a unit area of the side wall 50h1 from the preset position of the bent section 50d to an edge (the first edge 50d1 or the second edge 50d2) thereof. The total volume of the grooves 66 is the same as that in the foregoing examples. For details, refer to the foregoing examples, and details are not described herein again.

The reason is that when the foldable mobile phone 100 falls in an unfolded state, a corner of the flexible display 10 is most likely to collide with the preset position. Therefore, strength of a region that is in the fixing portion 51 and that is most likely to collide with the corner of the flexible display 10 is reduced to release stress. However, if all regions of the fixing portion 51 at the bent section 50d are weakened (i.e., the groove having the same volume as the preset position is provided), the strength of the screen decorating member 50 here (at the bent section 50d) may be reduced, affecting the function of the screen decorating member 50. Therefore, in the embodiments of this application, it is set that the total volume of the grooves 66 gradually decreases from the preset position of the bent section 50d to the edge (the first edge 50d1 and/or the second edge 50d2) thereof, so that while the flexible display 10 is protected, the strength of the screen decorating member 50 can be kept to the greatest extent.

The total volume of the grooves 66 gradually decreases in a unit area of the side wall 50h1 from the preset position of the bent section 50d to an edge thereof in the unit area of the blocking surface in a plurality of manners. Several feasible manners are described below. The following description does not constitute a limitation on this application.

In a possible implementation, still referring to FIG. 34, a plurality of grooves 66 are provided. A distance between two adjacent grooves 66 gradually increases from the preset position of the bent section 50d to an edge thereof.

For example, five grooves 66 are provided. The five grooves 66 include a first groove 661, a second groove 662, a third groove 663, a fourth groove 664, and a fifth groove 665. The second groove 662, the third groove 663, and the fourth groove 664 are located between the first groove 661 and the fifth groove 665. The third groove 663 is located between the second groove 662 and the fourth groove 664. A distance between the first groove 661 and the second groove 662 is L6, a distance between the second groove 662 and the third groove 663 is L7, a distance between the third groove 663 and the fourth groove 664 is L7, a distance between the fourth groove 664 and the fifth groove 665 is L6, and L6 > L7.

In another possible implementation, FIG. 35 is a schematic diagram of a structure of another fixing portion at a bent section according to an embodiment of this application. As shown in FIG. 35, a plurality of grooves 66 are provided. Volumes of the plurality of grooves 66 gradually decrease from the preset position of the bent section 50d to an edge thereof.

For example, five grooves 66 are provided. The five grooves 66 include a first groove 661, a second groove 662, a third groove 663, a fourth groove 664, and a fifth groove 665. The second groove 662, the third groove 663, and the fourth groove 664 are located between the first groove 661 and the fifth groove 665. The third groove 663 is located between the second groove 662 and the fourth groove 664. A volume of the first groove 561 is V6, a volume of the second groove 562 is V7, a volume of the third groove 563 is V8, a volume of the fourth groove 564 is V7, a volume of the fifth groove 565 is V6, and V8 > V7 > V6.

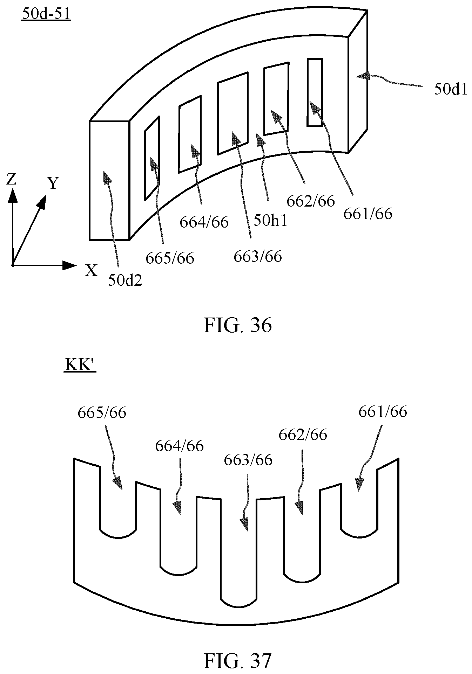

In this case, lengths (as shown in FIG. 35), widths (as shown in FIG. 36), and/or depths (as shown in FIG. 37) of the first groove 661, the second groove 662, the third groove 663, the fourth groove 664, and the fifth groove 665 may gradually decrease, so that the volumes of the plurality of grooves 66 gradually decrease from the preset position of the bent section 50d to an edge thereof.

It should be noted that, a length of the groove 66 is a size of the groove 66 in the Z-axis direction. A width of the groove 66 is a size of the groove 66 in a direction from the preset position of the bent section 50d to an edge thereof. A depth of the groove 66 is a size of the groove 66 in the direction of the blocking portion 52 pointing to the fixing portion 51.

In other words, for the grooves 66, the density gradually changes and the sizes gradually changes separately, so that a total volume of the grooves 66 in the bent section 50d gradually changes in a unit area from the preset position of the bent section 50d to an edge thereof. Certainly, the density of the grooves 66 may gradually change and at the same time the sizes of the grooves 66 also gradually change, so that a total volume of the grooves 66 in the bent section 50d gradually changes in a unit area from the preset position of the bent section 50d to an edge thereof.

In still another example, a material of the fixing portion 51 at the bent section 50d is different from a material of the fixing portion 51 at the first decorating section 50a. For example, a hardness of the material of the fixing portion 51 at the bent section 50d is less than a hardness of the material of the fixing portion 51 at the first decorating section 50a.

When the fixing portion 51 at the bent section 50d is soft, the strength of the fixing portion 51 at the bent section 50d can be reduced. Partial stress is released through the fixing portion 51 after a corner of the flexible display 10 collides with the fixing portion 51, thereby achieving the objective of protecting the flexible display 10.

A specific structure of the second end portion 50b2 at the second decorating member 50b and a specific structure of the bent section 50d are described above. Through the second end portion 50b2 and the bent section 50d, an effect of protecting the flexible display 10 can be achieved. In addition, strength of a partial region of the screen decorating member 50 is reduced. Therefore, through the foregoing arrangement, when the foldable mobile phone 100 is closed (folded), the frequency of an impact sound of the first decorating member 53 and the second decorating member 54 is reduced, and the timbre is deeper and steadier.

When the foldable mobile phone 100 is closed (folded), positions at which the first decorating member 53 and the second decorating member 54 generate the largest impact sound are generally positions at which the attraction structures are disposed.

Generally, the attraction structures are disposed in two manners. In one arrangement manner, the attraction structures are disposed at the bent section 50d. To be specific, the first attraction structure 61 is disposed at the bent section 50d of the first decorating member 53, and the second attraction structure 61 is disposed at the bent section 50d of the second decorating member 54. In the other arrangement manner, the attraction structures are disposed at the first decorating section 50a or the second decorating section 50b. To be specific, the first attraction structure 61 is disposed at the first decorating section 50a or the second decorating section 50b, and the second attraction structure 62 is disposed at the first decorating section 50a or the second decorating section 50b of the second decorating member 54.

When the attraction structure is disposed at the first decorating section 50a or the second decorating section 50b, for example, disposed at the first end portion 50a1 or the second end portion 50a2 of the first decorating section 50a, or at the first end portion 50b of the second decorating section 50b. A distance from an edge of a side of the first end portion 50a1 of the first decorating section 50a away from the first bent section 50d1 to the first bent section 50d1 is greater than 0 mm and less than or equal to 70 mm. A distance from an edge of a side of the second end portion 50a2 of the first decorating section 50a away from the second bent section 50d2 to the second bent section 50d2 is greater than 0 and less than or equal to 70 mm. A distance from an edge of a side of the first end portion 50b of the second decorating section 50b away from the bent section 50d to the bent section 50b is greater than 0 mm and less than or equal to 30 mm. For example, the attraction structure is disposed at the first end portion 50a1 of the first decorating section 50a, and a distance from the attraction structure to a second decorating section 50b closest to the attraction structure ranges from 0 mm to 70 mm, and is, for example, 20 mm, 30 mm, 40 mm, 50 mm, 60 mm, or 70 mm. For example, the attraction structure is disposed at the second end portion 50a2 of the first decorating section 50a, and a distance from the attraction structure to a second decorating section 50b closest to the attraction structure ranges from 0 mm to 70 mm, and is, for example, 20 mm, 30 mm, 40 mm, 50 mm, 60 mm, or 70 mm. For example, the attraction structure is disposed at the first end portion 50b of the second decorating section 50b, and a distance from the attraction structure to the bent section 50d ranges from 0 mm to 30 mm, and is, for example, 10 mm, 20 mm, or 30 mm.

That the first attraction structure 61 is disposed at the bent section 50d of the first decorating member 53 may be that a projection of the first decorating member 53 onto the plane formed by the X axis and the Y axis overlaps a projection of the bent section 50d of the first decorating member 53 onto the plane formed by the X axis and the Y axis, or may be that a projection of the first decorating member 53 onto the plane formed by the X axis and the Y axis is closest to a projection of the bent section 50d of the first decorating member 53 onto the plane formed by the X axis and the Y axis.

That the second attraction structure 62 is disposed at the bent section 50d of the second decorating member 54 may be that a projection of the second attraction structure 62 onto the plane formed by the X axis and the Y axis overlaps a projection of the bent section 50d of the second decorating member 54 onto the plane formed by the X axis and the Y axis, or may be that a projection of the second attraction structure 62 onto the plane formed by the X axis and the Y axis is closest to a projection of the bent section 50d of the second decorating member 54 onto the plane formed by the X axis and the Y axis.

That the first attraction structure 61 is disposed at the first decorating section 50a or the second decorating section 50b may be that a projection of the first attraction structure 61 onto the plane formed by the X axis and the Y axis overlaps a projection of the first decorating section 50a or the second decorating section 50b onto the plane formed by the X axis and the Y axis, or may be that a projection of the first attraction structure 61 onto the plane formed by the X axis and the Y axis is closest to a projection of the first decorating section 50a or the second decorating section 50b onto the plane formed by the X axis and the Y axis.

That the second attraction structure 62 is disposed at the first decorating section 50a or the second decorating section 50b may be that a projection of the second attraction structure 62 onto the plane formed by the X axis and the Y axis overlaps a projection of the first decorating section 50a or the second decorating section 50b onto the plane formed by the X axis and the Y axis, or may be that a projection of the second attraction structure 62 onto the plane formed by the X axis and the Y axis is closest to a projection of the first decorating section 50a or the second decorating section 50b onto the plane formed by the X axis and the Y axis.

When the attraction structure is disposed at the bent section 50d, through the bent section 50d (the embodiments corresponding to FIG. 26 to FIG. 33), the frequency of an impact sound of the first decorating member 53 and the second decorating member 54 can be reduced, and the timbre is deeper and steadier.

When the attraction structure is disposed at the first decorating section 50a or the second decorating section 50b, to reduce the frequency of an impact sound of the first decorating member 53 and the second decorating member 54 and make the timbre deeper and steadier, the fixing portion 51 at the position may use a grooving design (i.e., a plurality of grooves are provided at the position), a size of the notch 50h here may be increased, a soft structure may be disposed at the notch 50h, or the like. A specific arrangement manner thereof is similar to that of the bent section 50d. For details, refer to the foregoing content, and details are not described herein again.

Because the strength of the screen decorating member 50 at this position is reduced, damage caused by a collision between an edge of the flexible display 10 and this position can also be avoided.

In summary, the foregoing embodiments are merely intended for describing the technical solutions of this application, but not for limiting this application. Although this application is described in detail with reference to the foregoing embodiments, a person of ordinary skill in the art should understand that modifications may still be made to the technical solutions described in the foregoing embodiments or make equivalent replacements to some technical features thereof, without departing from the scope of the technical solutions of embodiments of this application.

## Claims

1. A screen decorating member (50), used in an electronic device (100), the electronic device comprising a screen body (10), wherein the screen decorating member comprises a first decorating section (50a), a second decorating section (50b), and a bent section (50d), and the second decorating section comprises a first end portion (50a1) and a second end portion (50a2);
the first decorating section is connected to the first end portion of the second decorating section by the bent section, the second end portion is located on a side of the first end portion away from the bent section, and the first decorating section, the second decorating section, and the bent section are configured for being disposed around at least part of a circumference of the screen body;
and the second end portion, optionally also the bent section, are provided with a stress buffer structure;
wherein the electronic device further comprises a housing, the screen body is disposed on a side of the housing, and the screen decorating member comprises a first decorating surface (50f) and a second decorating surface (50g) that are opposite to each other in a first direction; the second decorating surface is locally recessed in the first direction toward an edge of the screen body to form a notch (50h); a part corresponding to the notch in the screen decorating member in the first direction is a blocking portion (52), and the blocking portion is configured for blocking the edge of the screen body; and another part other than the blocking portion in the screen decorating member is a fixing portion (51), and the fixing portion is configured for being fixed at a circumference of the housing;
wherein the blocking portion comprises a blocking surface facing the screen body; the blocking surface and a side wall of the fixing portion define the notch, and at least one groove (56) is opened in the blocking surface at the second end portion; and the stress buffer structure comprises the groove.

2. The screen decorating member according to claim 1, wherein the second decorating section further comprises a main body portion (50b3) located between the first end portion and the second end portion;
the second end portion comprises a first notch (50h), and the main body portion comprises a second notch (50h);
a width of the first notch is greater than a width of the second notch, the width of the notch is a size of the notch in a second direction, and the second direction is a direction of the blocking portion pointing to the fixing portion; and
the first notch comprises a first part (50h2) and a second part (50h3) that are adjacent in the second direction, the first part is a part that is in the first notch and that has a same width as the second notch, and the stress buffer structure comprises the second part.

3. The screen decorating member according to claim 2, wherein a width of the second part gradually decreases in a third direction, and the third direction is a direction of the second end portion pointing to the main body portion.

4. The screen decorating member according to claim 2 or 3, wherein a soft structure is disposed at the second part; and
the stress buffer structure further comprises the soft structure.

5. The screen decorating member according to claim 4, wherein when the width of the second part gradually decreases in the third direction, a width of the soft structure gradually increments on a gradient in the third direction, wherein
the width of the soft structure is a size of the soft structure in the second direction.

6. The screen decorating member according to claim 1, wherein a volume of the groove gradually decreases in a unit area of the blocking surface in a third direction, and the third direction is a direction of the second end portion pointing to the first end portion.

7. The screen decorating member according to claim 6, wherein a plurality of grooves are provided, and a distance between two adjacent grooves gradually increases in the third direction; or
wherein a plurality of grooves are provided, and volumes of the plurality of grooves gradually decrease in the third direction.

8. The screen decorating member according to claim 7, wherein lengths, widths, and/or depths of the plurality of grooves gradually decrease in the third direction;
the width of the groove is a size of the groove in the third direction, and the third direction is a direction of the second end portion pointing to a main body portion;
the width of the groove is a size of the groove in a second direction, and the second direction is a direction of the blocking portion pointing to the fixing portion; and
the depth of the groove is a size of the groove in the first direction.

9. The screen decorating member according to claim 1, wherein the second decorating section further comprises a main body portion located between the first end portion and the second end portion; and a hardness of the blocking portion at the second end portion is less than a hardness of the blocking portion at the main body portion; and
the stress buffer structure comprises the blocking portion at the second end portion;
wherein the first decorating surface is exposed from an outer side, and a protective layer is disposed on the first decorating surface and is configured for blocking the first decorating surface.

10. The screen decorating member according to claim 1, wherein the bent section comprises a third notch, the first end portion comprises a fourth notch, and the first decorating section comprises a fifth notch;
a width of the third notch is greater than widths/a width of the fourth notch and/or the fifth notch, the width of the notch is a size of the notch in a second direction, and the second direction is a direction of the blocking portion pointing to the fixing portion; and
the third notch comprises a third part and a fourth part that are adjacent in the second direction, the third part is a part that is in the third notch and that has a same width as the fourth notch and/or the fifth notch, and the stress buffer structure comprises the fourth part;
the bent section comprises a first edge and a second edge, the first edge is in contact with the first end portion, and the second edge is in contact with the first decorating section; and
a width of the fourth part gradually decreases from a preset position of the bent section to the first edge and/or the second edge.

11. The screen decorating member according to claim 10, wherein a soft structure is disposed at the fourth part; and
the stress buffer structure further comprises the soft structure;
when the width of the notch gradually decreases from the preset position of the bent section to the first edge and/or the second edge, a width of the soft structure gradually increases from the preset position of the bent section to the first edge and/or the second edge, and the width of the soft structure is a size of the soft structure in the second direction.

12. An electronic device (100), comprising the screen decorating member according to any one of claims 1 to 11 and a screen body.

13. The electronic device according to claim 12, wherein the electronic device comprises a foldable terminal (100), and the foldable terminal further comprises a rotating shaft structure (40) and two bodies (20, 30); the screen body comprises a flexible display, and two screen decorating members (53, 54) are provided; the two bodies comprise a first body (20) and a second body (30), and the two screen decorating members comprise a first screen decorating member (53) and a second screen decorating member (54);
one end of the rotating shaft structure is connected to the first body, and the other end is connected to the second body;
the flexible display is located on a side of the rotating shaft structure, the first body, and the second body;
the flexible display comprises a bent display section (12) and a first flat display section (11) and a second flat display section (13) that are located on two sides of the bent display section;
the screen decorating members are located on a side of the flexible display away from the first body and the second body; and
the first screen decorating member is configured for blocking a gap between an edge of the first flat display section and the first body, and the second screen decorating member is configured for blocking a gap between an edge of the second flat display section and the second body.

## Patentansprüche

1. Bildschirmdekorationselement (50), das in einer elektronischen Vorrichtung (100) verwendet wird, wobei die elektronische Vorrichtung einen Bildschirmkörper (10) umfasst, wobei das Bildschirmdekorationselement einen ersten Dekorationsabschnitt (50a), einen zweiten Dekorationsabschnitt (50b) und einen gebogenen Abschnitt (50d) umfasst und der zweite Dekorationsabschnitt einen ersten Endabschnitt (50a1) und einen zweiten Endabschnitt (50a2) umfasst;
der erste Dekorationsabschnitt mit dem ersten Endabschnitt des zweiten Dekorationsabschnitts durch den gebogenen Abschnitt verbunden ist, der zweite Endabschnitt sich auf einer von dem gebogenen Abschnitt abgewandten Seite des ersten Endabschnitts befindet und der erste Dekorationsabschnitt, der zweite Dekorationsabschnitt und der gebogene Abschnitt dazu konfiguriert sind, um mindestens einen Teil eines Umfangs des Bildschirmkörpers herum angeordnet zu sein;
und der zweite Endabschnitt, optional auch der gebogene Abschnitt, mit einer Spannungspufferstruktur versehen ist bzw. sind;
wobei die elektronische Vorrichtung ferner ein Gehäuse umfasst, der Bildschirmkörper auf einer Seite des Gehäuses angeordnet ist und das Bildschirmdekorationselement eine erste Dekorationsfläche (50f) und eine zweite Dekorationsfläche (50g) umfasst, die in einer ersten Richtung einander gegenüberliegen; die zweite Dekorationsfläche in der ersten Richtung zu einem Rand des Bildschirmkörpers hin lokal vertieft ist, um eine Aussparung (50h) zu bilden; ein Teil, der der Aussparung in dem Bildschirmdekorationselement in der ersten Richtung entspricht, ein Blockierabschnitt (52) ist und der Blockierabschnitt dazu konfiguriert ist, den Rand des Bildschirmkörpers zu blockieren; und ein anderer Teil außer dem Blockierabschnitt in dem Bildschirmdekorationselement ein Befestigungsabschnitt (51) ist und der Befestigungsabschnitt dazu konfiguriert ist, an einem Umfang des Gehäuses befestigt zu sein;
wobei der Blockierabschnitt eine dem Bildschirmkörper zugewandte Blockierfläche umfasst; die Blockierfläche und eine Seitenwand des Befestigungsabschnitts die Aussparung definieren und mindestens eine Nut (56) in der Blockierfläche am zweiten Endabschnitt ausgebildet ist; und die Spannungspufferstruktur die Nut umfasst.

2. Bildschirmdekorationselement nach Anspruch 1, wobei der zweite Dekorationsabschnitt ferner einen Hauptkörperabschnitt (50b3) umfasst, der sich zwischen dem ersten Endabschnitt und dem zweiten Endabschnitt befindet;
der zweite Endabschnitt eine erste Aussparung (50h) umfasst und der Hauptkörperabschnitt eine zweite Aussparung (50h) umfasst;
eine Breite der ersten Aussparung größer als eine Breite der zweiten Aussparung ist, die Breite der Aussparung eine Abmessung der Aussparung in einer zweiten Richtung ist und die zweite Richtung eine Richtung des Blockierabschnitts ist, die auf den Befestigungsabschnitt zeigt; und
die erste Aussparung einen ersten Teil (50h2) und einen zweiten Teil (50h3) umfasst, die in der zweiten Richtung benachbart sind, der erste Teil ein Teil ist, der sich in der ersten Aussparung befindet und eine gleiche Breite wie die zweite Aussparung aufweist, und die Spannungspufferstruktur den zweiten Teil umfasst.

3. Bildschirmdekorationselement nach Anspruch 2, wobei eine Breite des zweiten Teils in einer dritten Richtung allmählich abnimmt und die dritte Richtung eine Richtung des zweiten Endabschnitts ist, die auf den Hauptkörperabschnitt zeigt.

4. Bildschirmdekorationselement nach Anspruch 2 oder 3, wobei eine weiche Struktur am zweiten Teil angeordnet ist; und
die Spannungspufferstruktur ferner die weiche Struktur umfasst.

5. Bildschirmdekorationselement nach Anspruch 4, wobei, wenn die Breite des zweiten Teils in der dritten Richtung allmählich abnimmt, eine Breite der weichen Struktur in der dritten Richtung stufenweise allmählich zunimmt, wobei
die Breite der weichen Struktur eine Abmessung der weichen Struktur in der zweiten Richtung ist.

6. Bildschirmdekorationselement nach Anspruch 1, wobei ein Volumen der Nut in einer Flächeneinheit der Blockierfläche in einer dritten Richtung allmählich abnimmt und die dritte Richtung eine Richtung des zweiten Endabschnitts ist, die auf den ersten Endabschnitt zeigt.

7. Bildschirmdekorationselement nach Anspruch 6, wobei eine Vielzahl von Nuten vorgesehen ist und ein Abstand zwischen zwei benachbarten Nuten in der dritten Richtung allmählich zunimmt; oder
wobei eine Vielzahl von Nuten vorgesehen ist und Volumina der Vielzahl von Nuten in der dritten Richtung allmählich abnehmen.

8. Bildschirmdekorationselement nach Anspruch 7, wobei Längen, Breiten und/oder Tiefen der Vielzahl von Nuten in der dritten Richtung allmählich abnehmen;
die Länge der Nut eine Abmessung der Nut in der dritten Richtung ist und die dritte Richtung eine Richtung des zweiten Endabschnitts ist, die auf einen Hauptkörperabschnitt zeigt;
die Breite der Nut eine Abmessung der Nut in einer zweiten Richtung ist und die zweite Richtung eine Richtung des Blockierabschnitts ist, die auf den Befestigungsabschnitt zeigt; und
die Tiefe der Nut eine Abmessung der Nut in der ersten Richtung ist.

9. Bildschirmdekorationselement nach Anspruch 1, wobei der zweite Dekorationsabschnitt ferner einen Hauptkörperabschnitt umfasst, der sich zwischen dem ersten Endabschnitt und dem zweiten Endabschnitt befindet; und eine Härte des Blockierabschnitts am zweiten Endabschnitt geringer als eine Härte des Blockierabschnitts am Hauptkörperabschnitt ist; und
die Spannungspufferstruktur den Blockierabschnitt am zweiten Endabschnitt umfasst;
wobei die erste Dekorationsfläche von einer Außenseite freiliegt und eine Schutzschicht auf der ersten Dekorationsfläche angeordnet ist und dazu konfiguriert ist, die erste Dekorationsfläche abzudecken.

10. Bildschirmdekorationselement nach Anspruch 1, wobei der gebogene Abschnitt eine dritte Aussparung umfasst, der erste Endabschnitt eine vierte Aussparung umfasst und der erste Dekorationsabschnitt eine fünfte Aussparung umfasst;
eine Breite der dritten Aussparung größer als Breiten/eine Breite der vierten Aussparung und/oder der fünften Aussparung ist, die Breite der Aussparung eine Abmessung der Aussparung in einer zweiten Richtung ist und die zweite Richtung eine Richtung des Blockierabschnitts ist, die auf den Befestigungsabschnitt zeigt; und
die dritte Aussparung einen dritten Teil und einen vierten Teil umfasst, die in der zweiten Richtung benachbart sind, der dritte Teil ein Teil ist, der sich in der dritten Aussparung befindet und eine gleiche Breite wie die vierte Aussparung und/oder die fünfte Aussparung aufweist, und die Spannungspufferstruktur den vierten Teil umfasst;
der gebogene Abschnitt einen ersten Rand und einen zweiten Rand umfasst, der erste Rand in Kontakt mit dem ersten Endabschnitt steht und der zweite Rand in Kontakt mit dem ersten Dekorationsabschnitt steht; und
eine Breite des vierten Teils von einer voreingestellten Position des gebogenen Abschnitts zu dem ersten Rand und/oder dem zweiten Rand allmählich abnimmt.

11. Bildschirmdekorationselement nach Anspruch 10, wobei eine weiche Struktur am vierten Teil angeordnet ist; und
die Spannungspufferstruktur ferner die weiche Struktur umfasst;
wenn die Breite der Aussparung von der voreingestellten Position des gebogenen Abschnitts zu dem ersten Rand und/oder dem zweiten Rand allmählich abnimmt, eine Breite der weichen Struktur von der voreingestellten Position des gebogenen Abschnitts zu dem ersten Rand und/oder dem zweiten Rand allmählich zunimmt und die Breite der weichen Struktur eine Abmessung der weichen Struktur in der zweiten Richtung ist.

12. Elektronische Vorrichtung (100), umfassend das Bildschirmdekorationselement nach einem der Ansprüche 1 bis 11 und einen Bildschirmkörper.

13. Elektronische Vorrichtung nach Anspruch 12, wobei die elektronische Vorrichtung ein faltbares Endgerät (100) umfasst und das faltbare Endgerät ferner eine Drehwellenstruktur (40) und zwei Körper (20, 30) umfasst; der Bildschirmkörper eine flexible Anzeige umfasst und zwei Bildschirmdekorationselemente (53, 54) vorgesehen sind; die zwei Körper einen ersten Körper (20) und einen zweiten Körper (30) umfassen und die zwei Bildschirmdekorationselemente ein erstes Bildschirmdekorationselement (53) und ein zweites Bildschirmdekorationselement (54) umfassen;
ein Ende der Drehwellenstruktur mit dem ersten Körper verbunden ist und das andere Ende mit dem zweiten Körper verbunden ist;
die flexible Anzeige sich auf einer Seite der Drehwellenstruktur, des ersten Körpers und des zweiten Körpers befindet;
die flexible Anzeige einen gebogenen Anzeigeabschnitt (12) und einen ersten flachen Anzeigeabschnitt (11) und einen zweiten flachen Anzeigeabschnitt (13) umfasst, die sich auf zwei Seiten des gebogenen Anzeigeabschnitts befinden;
die Bildschirmdekorationselemente sich auf einer von dem ersten Körper und dem zweiten Körper abgewandten Seite der flexiblen Anzeige befinden; und
das erste Bildschirmdekorationselement dazu konfiguriert ist, einen Spalt zwischen einem Rand des ersten flachen Anzeigeabschnitts und dem ersten Körper abzudecken, und das zweite Bildschirmdekorationselement dazu konfiguriert ist, einen Spalt zwischen einem Rand des zweiten flachen Anzeigeabschnitts und dem zweiten Körper abzudecken.

## Revendications

1. Élément de décoration d'écran (50), utilisé dans un dispositif électronique (100), le dispositif électronique comprenant un corps d'écran (10), dans lequel l'élément de décoration d'écran comprend une première section de décoration (50a), une seconde section de décoration (50b) et une section pliée (50d), et la seconde section de décoration comprend une première partie d'extrémité (50a1) et une seconde partie d'extrémité (50a2) ;
la première section de décoration est reliée à la première partie d'extrémité de la seconde section de décoration par la section pliée, la seconde partie d'extrémité est située sur un côté de la première partie d'extrémité opposé à la section pliée, et la première section de décoration, la seconde section de décoration et la section pliée sont configurées pour être disposées autour d'au moins une partie d'une circonférence du corps d'écran ;
et la seconde partie d'extrémité, éventuellement également la section pliée, est ou sont pourvue(s) d'une structure tampon de contrainte ;
dans lequel le dispositif électronique comprend en outre un boîtier, le corps d'écran est disposé sur un côté du boîtier, et l'élément de décoration d'écran comprend une première surface de décoration (50f) et une seconde surface de décoration (50g) qui sont opposées l'une à l'autre dans une première direction ; la seconde surface de décoration est localement évidée dans la première direction vers un bord du corps d'écran pour former une encoche (50h) ; une partie correspondant à l'encoche dans l'élément de décoration d'écran dans la première direction est une partie de blocage (52), et la partie de blocage est configurée pour bloquer le bord du corps d'écran ; et une autre partie autre que la partie de blocage dans l'élément de décoration d'écran est une partie de fixation (51), et la partie de fixation est configurée pour être fixée au niveau d'une circonférence du boîtier ;
dans lequel la partie de blocage comprend une surface de blocage faisant face au corps d'écran ; la surface de blocage et une paroi latérale de la partie de fixation définissent l'encoche, et au moins une rainure (56) est ménagée dans la surface de blocage au niveau de la seconde partie d'extrémité ; et la structure tampon de contrainte comprend la rainure.

2. Élément de décoration d'écran selon la revendication 1, dans lequel la seconde section de décoration comprend en outre une partie de corps principal (50b3) située entre la première partie d'extrémité et la seconde partie d'extrémité ;
la seconde partie d'extrémité comprend une première encoche (50h), et la partie de corps principal comprend une deuxième encoche (50h) ;
une largeur de la première encoche est supérieure à une largeur de la deuxième encoche, la largeur de l'encoche est une dimension de l'encoche dans une deuxième direction, et la deuxième direction est une direction de la partie de blocage pointant vers la partie de fixation ; et
la première encoche comprend une première partie (50h2) et une deuxième partie (50h3) qui sont adjacentes dans la deuxième direction, la première partie est une partie qui se trouve dans la première encoche et qui a une même largeur que la deuxième encoche, et la structure tampon de contrainte comprend la deuxième partie.

3. Élément de décoration d'écran selon la revendication 2, dans lequel une largeur de la deuxième partie diminue progressivement dans une troisième direction, et la troisième direction est une direction de la seconde partie d'extrémité pointant vers la partie de corps principal.

4. Élément de décoration d'écran selon la revendication 2 ou 3, dans lequel une structure souple est disposée au niveau de la deuxième partie ; et
la structure tampon de contrainte comprend en outre la structure souple.

5. Élément de décoration d'écran selon la revendication 4, dans lequel lorsque la largeur de la deuxième partie diminue progressivement dans la troisième direction, une largeur de la structure souple augmente progressivement par paliers dans la troisième direction, dans lequel
la largeur de la structure souple est une dimension de la structure souple dans la deuxième direction.

6. Élément de décoration d'écran selon la revendication 1, dans lequel un volume de la rainure diminue progressivement dans une surface unitaire de la surface de blocage dans une troisième direction, et la troisième direction est une direction de la seconde partie d'extrémité pointant vers la première partie d'extrémité.

7. Élément de décoration d'écran selon la revendication 6, dans lequel une pluralité de rainures sont prévues, et une distance entre deux rainures adjacentes augmente progressivement dans la troisième direction ; ou
dans lequel une pluralité de rainures sont prévues, et des volumes de la pluralité de rainures diminuent progressivement dans la troisième direction.

8. Élément de décoration d'écran selon la revendication 7, dans lequel des longueurs, largeurs et/ou profondeurs de la pluralité de rainures diminuent progressivement dans la troisième direction ;
la longueur de la rainure est une dimension de la rainure dans la troisième direction, et la troisième direction est une direction de la seconde partie d'extrémité pointant vers une partie de corps principal ;
la largeur de la rainure est une dimension de la rainure dans une deuxième direction, et la deuxième direction est une direction de la partie de blocage pointant vers la partie de fixation ; et
la profondeur de la rainure est une dimension de la rainure dans la première direction.

9. Élément de décoration d'écran selon la revendication 1, dans lequel la seconde section de décoration comprend en outre une partie de corps principal située entre la première partie d'extrémité et la seconde partie d'extrémité ; et une dureté de la partie de blocage au niveau de la seconde partie d'extrémité est inférieure à une dureté de la partie de blocage au niveau de la partie de corps principal ; et
la structure tampon de contrainte comprend la partie de blocage au niveau de la seconde partie d'extrémité ;
dans lequel la première surface de décoration est exposée depuis un côté extérieur, et une couche protectrice est disposée sur la première surface de décoration et est configurée pour recouvrir la première surface de décoration.

10. Élément de décoration d'écran selon la revendication 1, dans lequel la section pliée comprend une troisième encoche, la première partie d'extrémité comprend une quatrième encoche et la première section de décoration comprend une cinquième encoche ;
une largeur de la troisième encoche est supérieure à des largeurs/une largeur de la quatrième encoche et/ou de la cinquième encoche, la largeur de l'encoche est une dimension de l'encoche dans une deuxième direction, et la deuxième direction est une direction de la partie de blocage pointant vers la partie de fixation ; et
la troisième encoche comprend une troisième partie et une quatrième partie qui sont adjacentes dans la deuxième direction, la troisième partie est une partie qui se trouve dans la troisième encoche et qui a une même largeur que la quatrième encoche et/ou la cinquième encoche, et la structure tampon de contrainte comprend la quatrième partie ;
la section pliée comprend un premier bord et un second bord, le premier bord est en contact avec la première partie d'extrémité et le second bord est en contact avec la première section de décoration ; et
une largeur de la quatrième partie diminue progressivement depuis une position prédéfinie de la section pliée jusqu'au premier bord et/ou au second bord.

11. Élément de décoration d'écran selon la revendication 10, dans lequel une structure souple est disposée au niveau de la quatrième partie ; et
la structure tampon de contrainte comprend en outre la structure souple ;
lorsque la largeur de l'encoche diminue progressivement depuis la position prédéfinie de la section pliée jusqu'au premier bord et/ou au second bord, une largeur de la structure souple augmente progressivement depuis la position prédéfinie de la section pliée jusqu'au premier bord et/ou au second bord, et la largeur de la structure souple est une dimension de la structure souple dans la deuxième direction.

12. Dispositif électronique (100), comprenant l'élément de décoration d'écran selon l'une quelconque des revendications 1 à 11 et un corps d'écran.

13. Dispositif électronique selon la revendication 12, dans lequel le dispositif électronique comprend un terminal pliable (100), et le terminal pliable comprend en outre une structure d'arbre de rotation (40) et deux corps (20, 30) ; le corps d'écran comprend un écran flexible, et deux éléments de décoration d'écran (53, 54) sont prévus ; les deux corps comprennent un premier corps (20) et un second corps (30), et les deux éléments de décoration d'écran comprennent un premier élément de décoration d'écran (53) et un second élément de décoration d'écran (54) ;
une extrémité de la structure d'arbre de rotation est reliée au premier corps, et l'autre extrémité est reliée au second corps ;
l'écran flexible est situé sur un côté de la structure d'arbre de rotation, du premier corps et du second corps ;
l'écran flexible comprend une section d'affichage pliée (12) et une première section d'affichage plate (11) et une seconde section d'affichage plate (13) qui sont situées sur deux côtés de la section d'affichage pliée ;
les éléments de décoration d'écran sont situés sur un côté de l'écran flexible opposé au premier corps et au second corps ; et
le premier élément de décoration d'écran est configuré pour combler un espace entre un bord de la première section d'affichage plate et le premier corps, et le second élément de décoration d'écran est configuré pour combler un espace entre un bord de la seconde section d'affichage plate et le second corps.
